# EUROPEAN PATENT APPLICATION

(11) **EP 4 436 333 A1**
(43) Date of publication of application: **25.09.2024**
(21) Application number: 24165618.0
(22) Date of filing: 22.03.2024
(51) Int. Cl.: H10K 39/34, G06V 40/00, H10K 59/121, H10K 59/131, H10K 65/00

(54) **DISPLAY APPARATUS**

(30) Priority: 24.03.2023 KR 20230039038; 11.07.2023 KR 20230090026
(71) Applicant: Samsung Display Co., Ltd., Yongin-si, Gyeonggi-do 17113 (KR)
(72) Inventor: Bang, Jungsuk, 17113 Yongin-si (KR); Yoo, Dongil, 17113 Yongin-si (KR)
(74) Representative: Taor, Simon Edward William

(57) **Abstract**

A display apparatus including a plurality of pixels and a plurality of light detectors, the display apparatus including: a first electrode layer on a substrate and including a first connection line extending in a first direction; a second electrode layer on the first electrode layer, the second electrode layer including a first voltage line extending in a second direction crossing the first direction and a shielding portion protruding from the first voltage line in the first direction to overlap the first connection line; and a third electrode layer on the second electrode layer and including a second connection line and a signal line extending in the second direction.

## Description

### CROSS-REFERENCE TO RELATED APPLICATION

The present application claims priority to and the benefit of Korean Patent Application Nos. 10-2023-0039038 filed on March 24, 2023, and 10-2023-0090026, filed on July 11, 2023, in the Korean Intellectual Property Office.

### BACKGROUND

### 1. Field

Aspects of one or more embodiments relate to a display apparatus.

### 2. Description of the Related Art

An organic photodiode (OPD) uses an organic semiconductor to absorb incident light and convert the incident light into an electric current. The structure of the OPD is very similar to that of an organic light-emitting diode (OLED). Both of the OPD and the OLED include two electrodes arranged to face each other and a photoactive layer or emission layer positioned between the two electrodes. Using this structural similarity, an OLED and an OPD may be arranged together in a display area of a display apparatus.

In the display area thereof, lines for transmitting electric signals to be applied to the OLED and lines for transmitting electric signals generated by the OPD may be located.

The above information disclosed in this Background section is only for enhancement of understanding of the background and therefore the information discussed in this Background section does not necessarily constitute prior art.

### SUMMARY

As lines for transmitting electrical signals to be applied to a light-emitting diode and lines for transmitting electrical signals generated by a photodiode are located adjacent to each other, electrical interference may occur between the lines.

One or more embodiments include a display apparatus that displays high-quality images by preventing or reducing electrical interference between lines. Embodiments set forth herein are examples, and embodiments of the disclosure are not limited thereto.

Additional aspects will be set forth in part in the description which follows and, in part, will be apparent from the description, or may be learned by practice of the presented embodiments of the disclosure.

According to one or more embodiments, a display apparatus including a plurality of pixels and a plurality of light detectors includes a first electrode layer positioned on a substrate and including a first connection line extending in a first direction, a second electrode layer positioned on the first electrode layer, the second electrode layer including a first voltage line extending in a second direction crossing the first direction and a shielding portion protruding from the first voltage line in the first direction to overlap the first connection line, and a third electrode layer positioned on the second electrode layer and including a second connection line and a signal line extending in the second direction.

According to some embodiments, each of the plurality of light detectors may include a photo diode and a sensor circuit electrically connected to the photo diode, wherein the sensor circuit may include a first detection transistor including a gate electrode electrically connected to the photo diode, a first terminal, and a second terminal, a second detection transistor electrically connected between the gate electrode of the first detection transistor and the first voltage line, and a third detection transistor electrically connected between the second terminal of the first detection transistor and the signal line.

According to some embodiments, the shielding portion may overlap the second detection transistor.

According to some embodiments, the signal line may cross a sensor circuit area where the sensor circuit is arranged.

According to some embodiments, the signal line may extend along an imaginary straight line extending in the second direction.

According to some embodiments, the signal line may overlap the shielding portion.

According to some embodiments, the shielding portion may be integral with the first voltage line as a single body.

According to some embodiments, the shielding portion may extend from the first voltage line to overlap a region where the signal line and the first connection line cross each other.

According to some embodiments, the first connection line may have a first width in the second direction, and the shielding portion may have a second width in the second direction, wherein the first width may be less than the second width.

According to some embodiments, one boundary of the shielding portion extending in the first direction may be spaced apart from one boundary of the first connection line extending in the first direction to the outside of the first connection line by a first distance, wherein the first distance may be about 2 µm to about 5 µm.

According to some embodiments, the third electrode layer may further include a data line extending in the second direction, wherein the second connection line may be electrically connected to the data line and the first connection line.

According to some embodiments, the second connection line and the data line may be integral with each other as a single body.

According to some embodiments, the first connection line may be electrically connected to the second connection line within a display area.

According to some embodiments, each of the plurality of pixels may include a light-emitting diode and a pixel circuit electrically connected to the light-emitting diode, wherein the pixel circuit may include a driving transistor including a gate electrode electrically connected to a first node, a first terminal electrically connected to a second node, and a second terminal electrically connected to a third node, a data write transistor electrically connected between a data line and the first node, a compensation transistor electrically connected between the first node and the third node, a first initialization transistor electrically connected between the first node and a first initialization voltage line, a second initialization transistor electrically connected between the third node and a second initialization voltage line, and a storage capacitor electrically connected between a second voltage line and the first node.

According to some embodiments, the second voltage line may overlap the compensation transistor and the first initialization transistor.

According to some embodiments, the third electrode layer may further include the data line, and the second connection line and the data line may cross a pixel circuit area where the pixel circuit is arranged.

According to some embodiments, each of the plurality of light detectors may include a photo diode and a sensor circuit electrically connected to the photo diode, the light-emitting diode may include a pixel electrode, an opposite electrode, and a first intermediate layer between the pixel electrode and the opposite electrode, and the photo diode may include a sensor electrode, an opposite electrode, and a second intermediate layer between the sensor electrode and the opposite electrode, wherein the opposite electrode of the light-emitting diode and the opposite electrode of the photo diode may be integrally provided as a single body.

According to some embodiments, the sensor circuit may be arranged between a first pixel circuit and a second pixel circuit adjacent to each other.

According to some embodiments, the first pixel circuit and the second pixel circuit may have a symmetrical shape with the sensor circuit therebetween.

According to some embodiments, the signal line may be arranged between a data line electrically connected to the first pixel circuit and a data line electrically connected to the second pixel circuit.

According to an aspect, there is provided a display apparatus as set out in claim 1. Additional features are set out in claims 2 to 15.

Other aspects, features, and characteristics than those described above will become more apparent from the following drawings, claims, and detailed description of the disclosure.

### BRIEF DESCRIPTION OF THE DRAWINGS

The above and other aspects, features, and characteristics of certain embodiments of the disclosure will be more apparent from the following description taken in conjunction with the accompanying drawings, in which:
FIG. 1 is a plan view schematically illustrating a display apparatus according to some embodiments;
FIGS. 2A and 2B are plan views schematically illustrating a display apparatus according to some embodiments;
FIG. 3 is a cross-sectional view schematically illustrating a display apparatus according to some embodiments;
FIG. 4 is a cross-sectional view schematically illustrating a display apparatus according to some embodiments;
FIG. 5 is an equivalent circuit diagram schematically illustrating one pixel and one light detector included in a display apparatus, according to some embodiments;
FIG. 6 is a layout diagram schematically illustrating a display apparatus according to some embodiments;
FIGS. 7 to 14 are level-by-level layout diagrams schematically illustrating a display apparatus according to some embodiments;
FIG. 15 is a cross-sectional view schematically illustrating a display apparatus according to some embodiments;
FIG. 16A is a plan view of a display apparatus according to a comparative example, and FIGS. 16B and 16C are plan views of a display apparatus according to some embodiments;
FIG. 17 is a graph showing parasitic capacitance between lines of the display apparatuses shown in FIGS. 16A, 16B, and 16C according to some embodiments;
FIGS. 18A and 18B are plan views of a display apparatus according to some embodiments; and
FIG. 19A is a graph showing parasitic capacitance according to a distance between a boundary of a data line and a boundary of a shielding portion, and FIG. 19B is a table showing parasitic capacitance according to a distance between a boundary of a data line and a boundary of a shielding portion.

### DETAILED DESCRIPTION

Reference will now be made in more detail to aspects of some embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c, or any combination thereof.

Various modifications may be applied to the present embodiments, and particular embodiments will be illustrated in the drawings and described in the detailed description section. The effect and features of the present embodiments, and a method to achieve the same, will be clearer referring to the detailed descriptions below with the drawings. However, the present embodiments may be implemented in various forms, not by being limited to the embodiments presented below.

Hereinafter, aspects of some embodiments will be described in more detail with reference to the accompanying drawings, and in the description with reference to the drawings, the same or corresponding constituents are indicated by the same reference numerals and redundant descriptions thereof are omitted.

In the following embodiments, it will be understood that although the terms "first," "second," etc. may be used herein to describe various components, these components should not be limited by these terms. These terms are only used to distinguish one component from another.

In the following embodiments, as used herein, the singular forms are intended to include the plural forms as well, unless the context clearly indicates otherwise.

In the following embodiments, it will be further understood that the terms "include", "comprise", and/or "have" used herein specify the presence of stated features or components, but do not preclude the presence or addition of one or more other features or components.

In the following embodiments, it will be understood that when a layer, region, or component is referred to as being "formed on" another layer, region, or component, it can be directly or indirectly formed on the other layer, region, or component. That is, for example, intervening layers, regions, or components may be present.

In the following embodiments, it will be understood that when a layer, region, or component is referred to as being "connected to" another layer, region, or component, it can be directly connected to the other layer, region, or component or indirectly connected to the other layer, region, or component via intervening layers, regions, or components. For example, in the specification, when a layer, region, or component is referred to as being electrically connected to another layer, region, or component, it can be directly electrically connected to the other layer, region, or component or indirectly electrically connected to the other layer, region, or component via intervening layers, regions, or components.

In the present specification, when X and Y are connected, it may include a case in which X and Y are electrically connected, a case in which X and Y are functionally connected, and a case in which X and Y are directly connected. Here, X and Y may be objects (e.g., devices, elements, circuits, lines, electrodes, terminals, conductive films, layers, or the like). Accordingly, a connection relationship is not limited to, for example, a connection relationship indicated in the drawings or the detailed description, and may include a connection relationship other than the connection relationship indicated in the drawings or the detailed description.

When X and Y are electrically connected, it may include a case in which one or more elements (e.g., switches, transistors, capacitors, inductors, resistors, diodes, etc.) enabling electrical connection between X and Y are connected between X and Y.

Sizes of components in the drawings may be exaggerated for convenience of explanation. For example, because sizes and thicknesses of components in the drawings are arbitrarily illustrated for convenience of explanation, the following embodiments are not limited thereto.

The x-axis, the y-axis and the z-axis are not limited to three axes of the rectangular coordinate system, and may be interpreted in a broader sense. For example, the x-axis, the y-axis, and the z-axis may be perpendicular to one another, or may represent different directions that are not perpendicular to one another.

When a certain embodiment may be implemented differently, a specific process order may be performed differently from the described order. For example, two consecutively described processes may be performed substantially at the same time or performed in an order opposite to the described order.

In the present specification, "ON" used in association with a state of an element may refer to an activated state of the element, and "OFF" may refer to an inactivated state of the element. "ON" used in association with a signal received by an element may refer to a signal for activating the element, and "OFF" may refer to a signal for deactivating the element. The element may be activated by a high-level voltage or a low-level voltage. For example, a p-channel transistor (p-type transistor) may be activated by a low-level voltage and an n-channel transistor (n-type transistor) may be activated by a high-level voltage. Accordingly, it should be understood that "ON" voltages for a p-type transistor and an n-type transistor are opposite (low versus high) voltage levels.

In the present specification, when a signal is supplied, it may denote that an on voltage (e.g., a high-level voltage) is supplied, and when a signal is not supplied, it may denote that an off voltage (e.g., a low-level voltage) is supplied.

A display apparatus according to one or more embodiments may be implemented as an electronic device, such as smartphones, mobile phones, smartwatches, navigation devices, game consoles, televisions (TVs), head units for vehicles, laptop computers, tablet computers, personal media players (PMPs), and personal digital assistants (PDAs). In addition, the display apparatus may be a flexible apparatus.

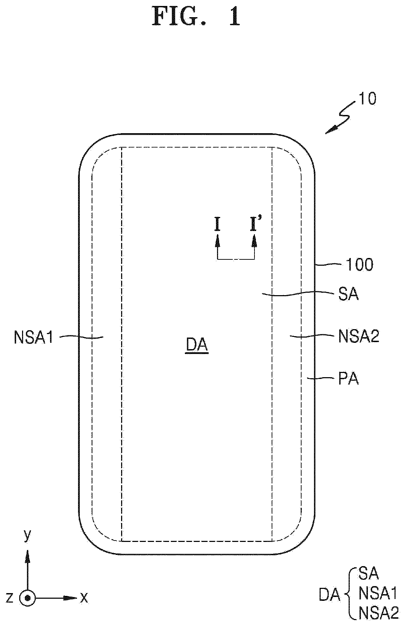

FIG. 1 is a plan view schematically illustrating a display apparatus 10 according to some embodiments.

The display apparatus 10 according to some embodiments may have a display area DA and a peripheral area PA outside (e.g., in a periphery or outside a footprint of) the display area DA. Regarding the display apparatus 10 including the display area DA and the peripheral area PA, it may be understood that the display area DA and the peripheral area PA are defined on a substrate 100 included in the display apparatus 10.

The substrate 100 may include various flexible, bendable, or rollable materials. For example, the substrate 100 may include a polymer resin, such as polyethersulfone, polyacrylate, polyetherimide, polyethylene naphthalate, polyethylene terephthalate, polyphenylene sulfide, polyarylate, polyimide, polycarbonate, or cellulose acetate propionate.

The substrate 100 may have a multi-layered structure including two layers and a barrier layer therebetween, wherein the two layers include a polymer resin as described above, and the barrier layer includes an inorganic material, such as silicon oxide, silicon nitride, silicon oxynitride, aluminum oxide, titanium oxide, tantalum oxide, hafnium oxide, or zinc oxide.

The display area DA may have a plurality of pixels arranged therein and may be an area in which an image is displayed. In a plan view, the display area DA may have a rectangular shape. According to some embodiments, the display area DA may have a polygonal shape, such as a triangle, a pentagon, and a hexagon, a circular shape, an elliptical shape, and an amorphous shape. The display area DA may have a shape with round edge corners.

According to some embodiments, as shown in FIG. 1, the display apparatus 10 may include the display area DA in which a length in a second direction (y direction) is greater than a length in a first direction (x direction). According to some embodiments, the display apparatus 10 may include the display area DA in which the length in the first direction (x direction) is greater than the length in the second direction (y direction). Embodiments according to the present disclosure are not limited thereto, however. For example, according to some embodiments, the display area DA may have an equal length in the first direction compared to the second direction. Additionally, according to some embodiments, the display area DA may have a circular, elliptical, or polygonal shape in a plan view (e.g., a view perpendicular or normal with respect to the display surface of the display area DA).

The display area DA may include a light detection area SA, a first non-detection area NSA1, and a second non-detection area NSA2, the first non-detection area NSA1 and the second non-detection area NSA2 being arranged at opposite sides of the light detection area SA, respectively. For example, in a central portion of the display area DA, the light detection area SA may extend from an upper side (+y direction) boundary of the display area DA to a lower (-y direction) boundary of the display area DA. The first non-detection area NSA1 may be arranged between a left (-x direction) boundary of the light detection area SA and the peripheral area PA, and the second non-detection area NSA2 may be arranged between a right (+x direction) boundary of the light detection area SA and the peripheral area PA.

The light detection area SA may be an area in which a plurality of light detectors are arranged between pixels to obtain image information or the like. In a plan view, the light detection area SA may have a rectangular shape in which a length in a second direction (y direction) is greater than a length in a first direction (x direction). The first non-detection area NSA1 and the second non-detection area NSA2 may be areas in which light detectors are not arranged.

The peripheral area PA may be arranged to surround at least a portion of the display area DA on the outside of the display area DA. The peripheral area PA may be a kind of non-display area in which pixels are not arranged. In addition, the peripheral area PA may be a kind of non-detection area in which light detectors are not arranged.

In the peripheral area PA, lines for transferring electrical signals to the display area DA, outer circuits electrically connected to pixel circuits and sensor circuits, and pads to which a printed circuit board or a driver integrated circuit (IC) chip is attached may be located. The pads arranged in the peripheral area PA may be exposed without being covered by an insulating layer and may be electrically connected to the printed circuit board, the driver IC chip, or the like.

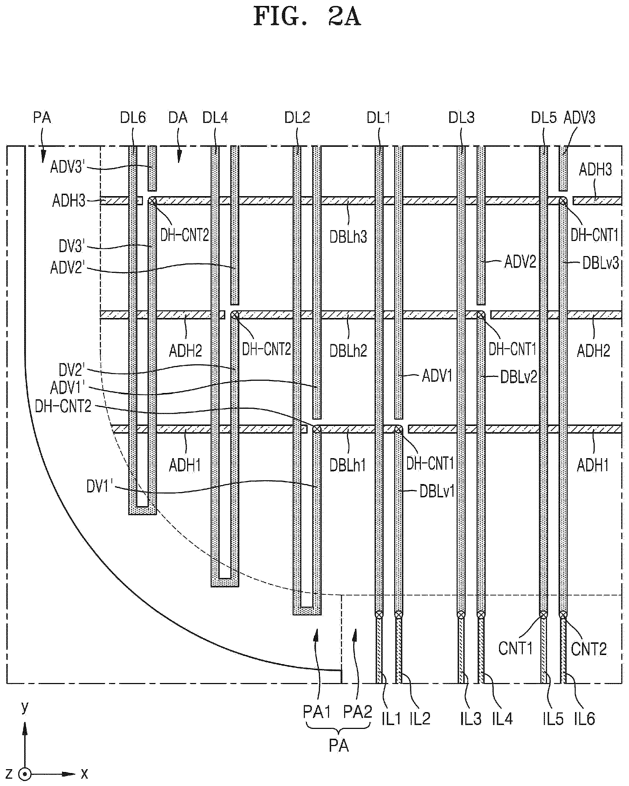

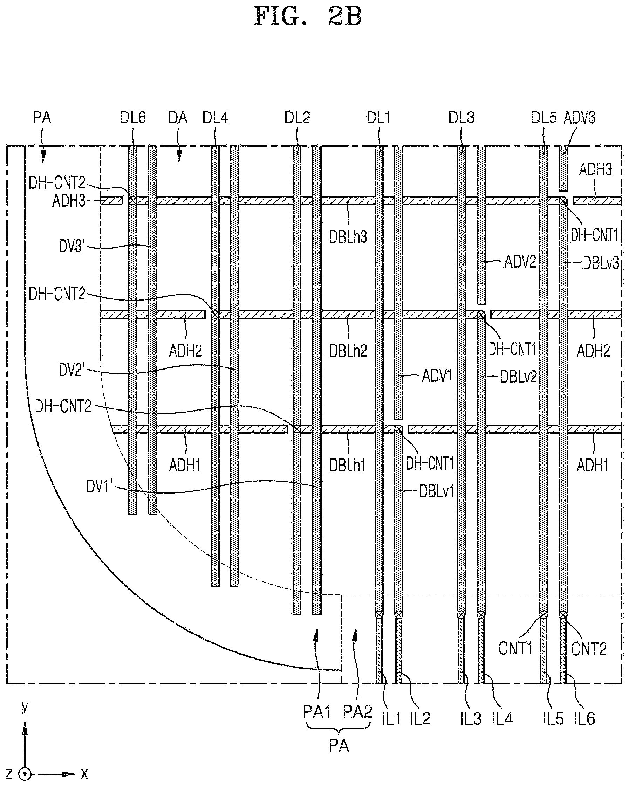

FIGS. 2A and 2B are plan views schematically illustrating a display apparatus according to some embodiments. FIGS. 2A and 2B are plan views schematically illustrating an enlarged portion of the display apparatus 10 shown in FIG. 1.

Various signals may be applied to the display area DA of the display apparatus 10. For example, a data signal for adjusting the brightness of each pixel may be applied to the display area DA. To this end, as shown in FIGS. 2A and 2B, data lines, for example, first to sixth data lines DL1 to DL6, arranged substantially parallel to each other in a first direction (x direction) and extending in a second direction (y direction) crossing the first direction (x direction) may be located in the display area DA. If necessary, the first to sixth data lines DL1 to DL6 may have a shape extending from the peripheral area PA into the display area DA, as shown in FIG. 2A. Various lines other than the first to sixth data lines DL1 to DL6, such as a power supply line or a scan line, may also be located inside or outside the display area DA.

The peripheral area PA may include a first peripheral area PA1 and a second peripheral area PA2. Input lines, for example, first to sixth input lines IL1 to IL6, may be located in the second peripheral area PA2. The first to sixth input lines IL1 to IL6 may be connected to a driver integrated circuit (IC) or the like to receive data signals. For example, the first data line DL1 to the sixth data line DL6 may be electrically connected to the first input line IL1 to the sixth input line IL6, respectively, and transmit data signals to pixels within the display area DA.

FIGS. 2A and 2B show six input lines IL1 to IL6 and six data lines DL1 to DL6 for convenience of description. However, one or more embodiments are not limited thereto, and the number of input lines and the number of data lines may each be six or more.

The first input line IL1 to the sixth input line IL6 may be spaced apart from each other in the first direction (x direction) and sequentially arranged in the second peripheral area PA2.

According to some embodiments, the first input line IL1, the third input line IL3, and the fifth input line IL5 positioned at odd numbers may be electrically connected to the first data line DL1, the third data line DL3, and the fifth data line DL5, respectively, which are located adjacent to each other. According to some embodiments, each of the first input line IL1, the third input line IL3, and the fifth input line IL5 may be formed integrally with a corresponding one of the first data line DL1, the third data line DL3, and the fifth data line DL5. Alternatively, as shown in FIGS. 2A and 2B, each of the first input line IL1, the third input line IL3, and the fifth input line IL5 may be electrically connected to a corresponding one of the first data line DL1, the third data line DL3, and the fifth data line DL5 through a first contact hole CNT1. In this case, the first data line DL1, the third data line DL3, and the fifth data line DL5 may be located on an insulating layer covering the first input line IL1, the third input line IL3, and the fifth input line IL5. Each of the first data line DL1, the third data line DL3, and the fifth data line DL5 may receive a data signal from a corresponding one of the first input line IL1, the third input line IL3, and the fifth input line IL5.

The second input line IL2, the fourth input line IL4, and the sixth input line IL6 positioned at even numbers may be electrically connected to the second data line DL2, the fourth data line DL4, and the sixth data line DL6, respectively, which are located adjacent to each other, through first connection lines extending in the first direction (x direction) and second connection lines extending in the second direction (y direction), as shown in FIGS. 2A and 2B. The first connection lines may include a first horizontal connection line DBLh1, a second horizontal connection line DBLh2, and a third horizontal connection line DBLh3, and the second connection lines may include a first vertical connection line DBLv1, a second vertical connection line DBLv2, and a third vertical connection line DBLv3. For example, the second data line DL2 may receive a data signal from the second input line IL2 through the first vertical connection line DBLv1 and the first horizontal connection line DBLh1, the fourth data line DL4 may receive a data signal from the fourth input line IL4 through the second vertical connection line DBLv2 and the second horizontal connection line DBLh2, and the sixth data line DL6 may receive a data signal from the sixth input line IL6 through the third vertical connection line DBLv3 and the third horizontal connection line DBLh3.

One end of each of the first vertical connection line DBLv1, the second vertical connection line DBLv2, and the third vertical connection line DBLv3 may be electrically connected to a corresponding one of the second input line IL2, the fourth input line IL4, and the sixth input line IL6 through a second contact hole CNT2, and the other end of each of the first vertical connection line DBLv1, the second vertical connection line DBLv2, and the third vertical connection line DBLv3 may be electrically connected to a corresponding one of the first horizontal connection line DBLh1, the second horizontal connection line DBLh2, and the third horizontal connection line DBLh3 through a third contact hole DH-CNT1.

Referring to FIG. 2A, one end of each of the first horizontal connection line DBLh1, the second horizontal connection line DBLh2, and the third horizontal connection line DBLh3 may be electrically connected to a corresponding one of the first vertical connection line DBLv1, the second vertical connection line DBLv2, and the third vertical connection line DBLv3 through the third contact hole DH-CNT1, and the other end of each of the first horizontal connection line DBLh1, the second horizontal connection line DBLh2, and the third horizontal connection line DBLh3 may be electrically connected to a corresponding one of a fourth vertical connection line DV1', a fifth vertical connection line DV2', and a sixth vertical connection line DV3' through a fourth contact hole DH-CNT2. Each of the fourth vertical connection line DV1', the fifth vertical connection line DV2', and the sixth vertical connection line DV3' may be integral with a corresponding one of the second data line DL2, the fourth data line DL4, and the sixth data line DL6.

According to some embodiments, the display apparatus 10 may further include dummy lines. For example, the display apparatus 10 may include a first auxiliary horizontal connection line ADH1 that is spaced apart from the first horizontal connection line DBLh1 and electrically insulated from the first horizontal connection line DBLh1 and the second data line DL2 and has the same extension axis as that of the first horizontal connection line DBLh1. For example, the display apparatus 10 may include a first auxiliary horizontal connection line ADH1 positioned on the left side (-x direction) of the first horizontal connection line DBLh1, and a first auxiliary horizontal connection line ADH1 positioned on the right side (+x direction) of the first horizontal connection line DBLh1. Similarly, the display apparatus 10 may include a second auxiliary horizontal connection line ADH2 that is spaced apart from the second horizontal connection line DBLh2 and electrically insulated from the second horizontal connection line DBLh2 and the fourth data line DL4 and has the same extension axis as that of the second horizontal connection line DBLh2. The display apparatus 10 may include a third auxiliary horizontal connection line ADH3 that is spaced apart from the third horizontal connection line DBLh3 and electrically insulated from the third horizontal connection line DBLh3 and the sixth data line DL6 and has the same extension axis as that of the third horizontal connection line DBLh3. Accordingly, the structural difference between pixels through which the first horizontal connection line DBLh1, the second horizontal connection line DBLh2, and the third horizontal connection line DBLh3 pass and pixels through which the first horizontal connection line DBLh1, the second horizontal connection line DBLh2, and the third horizontal connection line DBLh3 do not pass may be reduced. As a result, when the same electrical signal is applied to the pixels, the difference in luminance implemented in the pixels may be reduced, and thus, a display apparatus 10 capable of displaying high-quality images may be implemented.

Similarly, the display apparatus 10 according to some embodiments may include a first auxiliary vertical connection line ADV1, a second auxiliary vertical connection line ADV2, and a third auxiliary vertical connection line ADV3, which are spaced apart from and electrically insulated from the first vertical connection line DBLv1, the second vertical connection line DBLv2, and the third vertical connection line DBLv3, respectively, and have the same extension axes as those of the first vertical connection line DBLv1, the second vertical connection line DBLv2, and the third vertical connection line DBLv3, respectively. In addition, the display apparatus 10 may include a fourth auxiliary vertical connection line ADV1', a fifth auxiliary vertical connection line ADV2', and a sixth auxiliary vertical connection line ADV3', which are spaced apart from and electrically insulated from the fourth vertical connection line DV1', the fifth vertical connection line DV2', and the sixth vertical connection line DV3', respectively, and have the same extension axes as those of the fourth vertical connection line DV1', the fifth vertical connection line DV2', and the sixth vertical connection line DV3', respectively. Accordingly, the structural difference between pixels through which the first vertical connection line DBLv1, the second vertical connection line DBLv2, and the third vertical connection line DBLv3 pass and pixels through which the first vertical connection line DBLv1, the second vertical connection line DBLv2, and the third vertical connection line DBLv3 do not pass may be reduced. As a result, when the same electrical signal is applied to the pixels, the difference in luminance implemented in the pixels may be reduced, and thus, a display apparatus 10 capable of displaying high-quality images may be implemented.

Referring to FIG. 2B, one end of each of the first horizontal connection line DBLh1, the second horizontal connection line DBLh2, and the third horizontal connection line DBLh3 may be electrically connected to a corresponding one of the first vertical connection line DBLv1, the second vertical connection line DBLv2, and the third vertical connection line DBLv3 through a third contact hole DH-CNT1, and the other end of each of the first horizontal connection line DBLh1, the second horizontal connection line DBLh2, and the third horizontal connection line DBLh3 may be electrically connected to a corresponding one of a second data line DL2, a fourth data line DL4, and a sixth data line DL6 through a fourth contact hole DH-CNT2.

According to some embodiments, the display apparatus 10 may further include dummy lines. For example, the display apparatus 10 may include a first auxiliary horizontal connection line ADH1 that is spaced apart from the first horizontal connection line DBLh1 and electrically insulated from the first horizontal connection line DBLh1 and the second data line DL2 and has the same extension axis as that of the first horizontal connection line DBLh1. For example, the display apparatus 10 may include a first auxiliary horizontal connection line ADH1 positioned on the left side (-x direction) of the first horizontal connection line DBLh1, and a first auxiliary horizontal connection line ADH1 positioned on the right side (+x direction) of the first horizontal connection line DBLh1. Similarly, the display apparatus 10 may include a second auxiliary horizontal connection line ADH2 that is spaced apart from the second horizontal connection line DBLh2 and electrically insulated from the second horizontal connection line DBLh2 and the fourth data line DL4 and has the same extension axis as that of the second horizontal connection line DBLh2. The display apparatus 10 may include a third auxiliary horizontal connection line ADH3 that is spaced apart from the third horizontal connection line DBLh3 and electrically insulated from the third horizontal connection line DBLh3 and the sixth data line DL6 and has the same extension axis as that of the third horizontal connection line DBLh3.

Similarly, the display apparatus 10 according to some embodiments may include a first auxiliary vertical connection line ADV1, a second auxiliary vertical connection line ADV2, and a third auxiliary vertical connection line ADV3, which are spaced apart from and electrically insulated from the first vertical connection line DBLv1, the second vertical connection line DBLv2, and the third vertical connection line DBLv3, respectively, and have the same extension axes as those of the first vertical connection line DBLv1, the second vertical connection line DBLv2, and the third vertical connection line DBLv3, respectively.

In this case, the fourth vertical connection line DV1', the fifth vertical connection line DV2', and the sixth vertical connection line DV3' may be dummy lines not electrically connected to the data lines DL1 to DL6 and the input lines IL1 to IL6. Accordingly, the structural difference between pixels through which the first vertical connection line DBLv1, the second vertical connection line DBLv2, and the third vertical connection line DBLv3 pass and pixels through which the first vertical connection line DBLv1, the second vertical connection line DBLv2, and the third vertical connection line DBLv3 do not pass may be reduced. As a result, when the same electrical signal is applied to the pixels, the difference in luminance implemented in the pixels may be reduced, and thus, a display apparatus 10 capable of displaying high-quality images may be implemented.

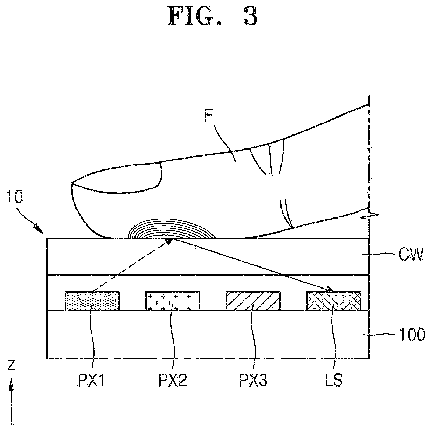

FIG. 3 is a cross-sectional view schematically illustrating the display apparatus 10 according to some embodiments.

Referring to FIG. 3, the display apparatus 10 according to some embodiments may include a substrate 100, and a first pixel PX1, a second pixel PX2, a third pixel PX3, a light detector LS, and a cover window CW located on the substrate 100.

Each of the first pixel PX1, the second pixel PX2, and the third pixel PX3 may include a light-emitting diode and a pixel circuit connected to the light-emitting diode, and the light detector LS may include a photo diode and a sensor circuit connected to the photo diode.

According to some embodiments, the first pixel PX1, the second pixel PX2, and the third pixel PX3 may emit light of different colors from each other. For example, the first pixel PX1 may emit light of a first color, the second pixel PX2 may emit light of a second color, and the third pixel PX3 may emit light of a third color. In this case, the light of the first color, the light of the second color, and the light of the third color may be red light, green light, and blue light, respectively. However, embodiments according to the present disclosure are not limited thereto.

The display apparatus 10 may have a function of sensing an object, for example, a fingerprint of a finger F, in contact with the cover window CW. According to some embodiments, light emitted from at least one of the first pixel PX1, the second pixel PX2, or the third pixel PX3 may be reflected by a fingerprint of a user and re-incident on the light detector LS. The light detector LS may detect reflected light and convert the light into an electric signal. For example, the light of the first color emitted by the first pixel PX1 is reflected by the fingerprint of the finger F in contact with the cover window CW and re-incident on the light detector LS, and the light detector LS may obtain a fingerprint pattern of the finger F.

In FIG. 3, an example in which information of an object in contact with the display apparatus 10 is obtained by using reflection of light emitted by the first pixel PX1 is illustrated. However, one or more embodiments are not limited thereto. The display apparatus 10 may detect an object not in contact with the cover window CW of the display apparatus 10.

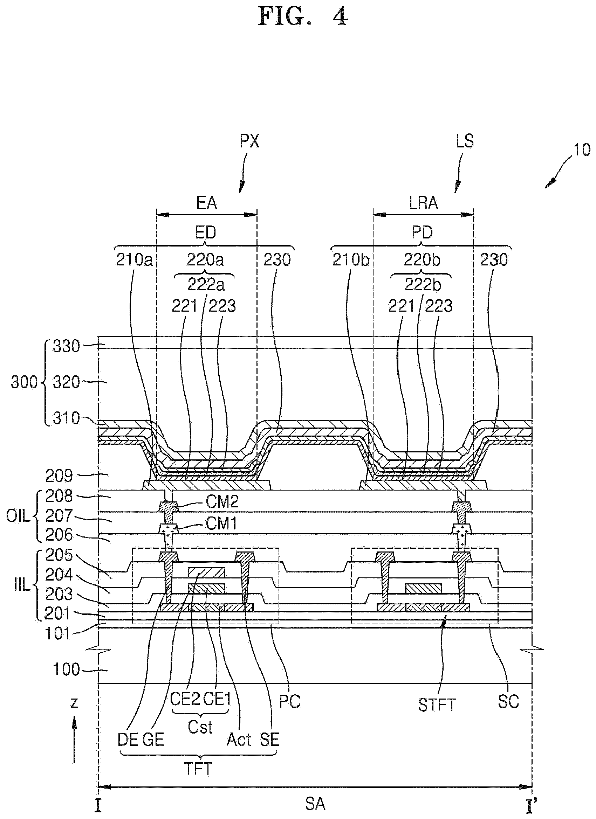

FIG. 4 is a cross-sectional view schematically illustrating a display apparatus 10 according to some embodiments. FIG. 4 is a cross-sectional view taken along a line I-I' in FIG. 1.

Referring to FIG. 4, a substrate 100 may include a light-detection area SA, and a pixel PX and a light detector LS may be located in the light-detection area SA. The pixel PX may include a light-emitting diode ED and a pixel circuit PC electrically connected to the light-emitting diode ED, and the light detector LS may include a photo diode PD and a sensor circuit SC electrically connected to the photo diode PD. The light-emitting diode ED may be an organic light-emitting diode, which is an emission element, and the photo diode PD may be an organic photodiode, which is a light-receiving element.

A barrier layer 101 may be located on the substrate 100. The barrier layer 101 may include an inorganic insulating material, such as silicon nitride, silicon oxide, or silicon oxynitride.

A buffer layer 201 may be located on the barrier layer 101. The barrier layer 101 and the buffer layer 201 may reduce or block permeation of foreign substances, moisture, or ambient air from a lower portion of the substrate 100 and provide a flat surface on the substrate 100. The buffer layer 201 may include an inorganic material, such as silicon nitride, silicon oxide, or silicon oxynitride, an organic material, or an organic/inorganic composite.

The pixel circuit PC and the sensor circuit SC may be located on the buffer layer 201.

The pixel circuit PC may include a thin-film transistor TFT and a storage capacitor Cst. The thin-film transistor TFT may include a semiconductor layer Act, the gate electrode GE, a source electrode SE, and a drain electrode DE, and the storage capacitor Cst may include a first electrode CE1 and a second electrode CE2.

The semiconductor layer Act may be located on the buffer layer 201. The semiconductor layer Act may include polysilicon. Alternatively, the semiconductor layer Act may include amorphous silicon, an oxide semiconductor, or an organic semiconductor. The semiconductor layer Act may include a channel region, and a drain region and a source area respectively arranged at opposite sides of the channel region.

The gate electrode GE may be located on the semiconductor layer Act. The gate electrode GE may overlap the channel region of the semiconductor layer Act. The gate electrode GE may include a low-resistance metal material. The gate electrode GE may include a conductive material including molybdenum (Mo), aluminum (Al), copper (Cu), titanium (Ti), or the like and may include a layer or layers including the aforementioned material.

A first gate insulating layer 203 may be arranged between the semiconductor layer Act and the gate electrode GE. The first gate insulating layer 203 may include an inorganic insulating material, such as silicon oxide, silicon nitride, silicon oxynitride, aluminum oxide, titanium oxide, tantalum oxide, hafnium oxide, or zinc oxide. The first gate insulating layer 203 may include a layer or layers including the inorganic insulating material described above.

A second gate insulating layer 204 may be located on the gate electrode GE to cover the gate electrode GE. The second gate insulating layer 204 may include an inorganic insulating material, such as silicon oxide, silicon nitride, silicon oxynitride, aluminum oxide, titanium oxide, tantalum oxide, hafnium oxide, or zinc oxide. The second gate insulating layer 204 may include a layer or layers including the inorganic insulating material described above.

The second electrode CE2 of the storage capacitor Cst may be located on the second gate insulating layer 204. At least a portion of the second electrode CE2 may overlap the gate electrode GE. In this case, the gate electrode GE overlapping the second electrode CE2 of the storage capacitor Cst may function as the first electrode CE1 of the storage capacitor Cst. For example, the gate electrode GE may be integrally formed as a single body with the first electrode CE1.

The second electrode CE2 may include a conductive material including Mo, Al, Cu, Ti, or the like and may include a layer or layers including the aforementioned material.

An interlayer insulating layer 205 may be located on the second electrode CE2. The interlayer insulating layer 205 may be formed to cover the second electrode CE2 and may include a layer or layers including the inorganic insulating materials described above. An inorganic insulating layer IIL may include the buffer layer 201, the first gate insulating layer 203, the second gate insulating layer 204, and the interlayer insulating layer 205.

The source electrode SE and the drain electrode DE may be located on the interlayer insulating layer 205. Each of the source electrode SE and the drain electrode DE may include a conductive material, including Mo, Al, Cu, and Ti, and may include a layer or layers including the material described above. For example, each of the source electrode SE and the drain electrode DE may include a multi-layered structure of Ti/Al/Ti. In some embodiments, the source electrode SE or the drain electrode DE may be omitted.

The sensor circuit SC may include a detection thin-film transistor STFT. The detection thin-film transistor STFT included in the sensor circuit SC may have a structure similar to a structure of the thin-film transistor TFT included in the pixel circuit PC.

Although FIG. 4 shows one thin-film transistor TFT and one detection thin-film transistor STFT for convenience of description, a plurality of thin-film transistors TFT and a plurality of detection thin-film transistors STFT may be provided. According to some embodiments, some of the plurality of thin-film transistors TFT and the plurality of detection thin-film transistors STFT may be silicon thin-film transistors including a silicon semiconductor layer, and the others may be an oxide thin-film transistor including an oxide semiconductor layer. In this case, the inorganic insulating layer IIL may further include insulating layers between the second gate insulating layer 204 and the interlayer insulating layer 205 to insulate an oxide semiconductor layer from a conductive layer located on the oxide semiconductor layer.

An organic insulating layer OIL may be arranged to cover the pixel circuit PC and the sensor circuit SC. The organic insulating layer OIL may include a first planarization layer 206, a second planarization layer 207, and a third planarization layer 208, which are sequentially stacked in a thickness direction (z direction).

The first planarization layer 206, the second planarization layer 207, and the third planarization layer 208 may provide a flat base surface to a pixel electrode 210a of the light-emitting diode ED and a detection electrode 210b of the photo diode PD, which are located on the first to third planarization layers 206 to 208.

Each of the first planarization layer 206, the second planarization layer 207, and the third planarization layer 208 may include general-purpose polymers, such as benzocyclobutene (BCB), polyimide, hexamethyldisiloxane (HMDSO), polymethylmethacrylate (PMMA), or polystyrene (PS), polymer derivatives having a phenol-based group, acryl-based polymers, imide-based polymers, aryl ether-based polymers, amide-based polymers, fluorine-based polymers, p-xylene-based polymers, or vinyl alcohol-based polymers. Each of the first planarization layer 206, the second planarization layer 207, and the third planarization layer 208 may include a layer or layers including the organic insulating materials described above.

A first connection electrode CM1 may be arranged between the first planarization layer 206 and the second planarization layer 207, and a second connection electrode CM2 may be arranged between the second planarization layer 207 and the third planarization layer 208. The first connection electrode CM1 may be connected to the drain electrode DE of the thin-film transistor TFT via a contact hole defined in the first planarization layer 206. The second connection electrode CM2 may be connected to the first connection electrode CM1 via a contact hole defined in the second planarization layer 207.

Each of the first connection electrode CM1 and the second connection electrode CM2 may include a conductive material including Mo, Al, Cu, Ti, or the like and may include a layer or layers including the aforementioned material.

The light-emitting diode ED and the photo diode PD may be located on the organic insulating layer OIL. The light-emitting diode ED may include the pixel electrode 21 0a, an opposite electrode 230, and a first intermediate layer 220a arranged between the pixel electrode 210a and the opposite electrode 230. The photo diode PD may include the detection electrode 21 0b, an opposite electrode 230, and a second intermediate layer 220b arranged between the detection electrode 210b and the opposite electrode 230. The opposite electrode 230 of the light-emitting diode ED and the opposite electrode 230 of the photo diode PD may be integrally provided as a single body.

The pixel electrode 210a and the detection electrode 210b may be located on the third planarization layer 208 to be apart from each other. The pixel electrode 210a may be electrically connected to the thin-film transistor TFT of the pixel circuit PC by the first connection electrode CM1 and the second connection electrode CM2.

The pixel electrode 210a may include a conductive oxide, such as indium tin oxide (ITO), indium zinc oxide (IZO), zinc oxide (ZnO), indium oxide (In₂O₃), indium gallium oxide (IGO), or aluminum zinc oxide (AZO). The pixel electrode 210a may include a reflective film including silver (Ag), magnesium (Mg), aluminum (Al), platinum (Pt), palladium (Pd), gold (Au), nickel (Ni), neodymium (Nd), iridium (Ir), chrome (Cr), or a compound or mixture thereof. According to some embodiments, the pixel electrode 210a may have a structure having films including ITO, IZO, ZnO, or In₂O₃, over/under the reflective film described above. The pixel electrode 210a may have a stack structure of ITO/Ag/ITO.

The detection electrode 210b may be electrically connected to the detection thin-film transistor STFT of the sensor circuit SC by the connection electrodes. The detection electrode 210b may have a structure identical or similar to a structure of the pixel electrode 210a.

A pixel-defining layer 209 may be located on the third planarization layer 208 to cover an edge of each of the pixel electrode 210a and the detection electrode 210b. The pixel-defining layer 209 may define an opening exposing a central portion of the pixel electrode 210a and an opening exposing a central portion of the detection electrode 210b. A size and shape of an emission area EA of the light-emitting diode ED may be defined by the opening exposing the central portion of the pixel electrode 210a. A size and shape of a light-receiving area LRA of the photo diode PD may be defined by the opening exposing the central portion of the detection electrode 210b.

The pixel-defining layer 209 may increase a distance between an edge of the pixel electrode 210a and the opposite electrode 230 and a distance between an edge of the detection electrode 210b and the opposite electrode 230, thereby preventing an arc or the like from occurring at the edge of the pixel electrode 210a and the edge of the detection electrode 21 0b. The pixel-defining layer 209 may include an organic insulating material, such as polyimide, polyamide, acrylic resin, benzocyclobutene, hexamethyldisiloxane (HMDSO), and phenolic resin, and may be formed by a method such as spin coating.

The first intermediate layer 220a may be located on the pixel electrode 210a. The first intermediate layer 220a may include an emission layer 222a, a first functional layer 221, and a second functional layer 223, wherein the emission layer 222a is arranged to correspond to the pixel electrode 210a, and the first functional layer 221 and the second functional layer 223 are located under and/or over the emission layer 222a.

The second intermediate layer 220b may be located on the detection electrode 210b. The second intermediate layer 220b may include an active layer 222b, a first functional layer 221 and a second functional layer 223, wherein the active layer 222b is arranged to correspond to the detection electrode 210b, and the first functional layer 221 and the second functional layer 223 are located under and/or over the active layer 222b. The first functional layer 221 and the second functional layer 223 may be common layers integrally provided as a single body across the light-emitting diode ED and the photo diode PD, respectively.

The emission layer 222a may include an organic material including a fluorescent or phosphorescent material emitting red, green, blue, or white light. The emission layer 222a may be an organic emission layer including a low-molecular weight organic material or a polymer organic material. For example, the emission layer 222a, which is an organic emission layer, may include copper phthalocyanine, tris-8-hydroxyquinoline aluminum, a poly-phenylenevinylene (PPV)-based material, or a polyflurorene-based materials.

According to some embodiments, the emission layer 222a may include a host material and a dopant material. The dopant material is a material emitting light of a specific color and may include a light-emitting material. The light-emitting material may include at least one of a phosphorescent dopant, a fluorescent dopant, or quantum dots.

The active layer 222b may include a p-type organic semiconductor and an n-type organic semiconductor. In this case, the p-type organic semiconductor may act as an electron donor and the n-type organic semiconductor may act as an electron acceptor.

According to some embodiments, the active layer 222b may be a mixed layer, in which the p-type organic semiconductor and the n-type organic semiconductor are mixed together. In this case, the active layer 222b may be formed by co-deposition of the p-type organic semiconductor and the n-type organic semiconductor. When the active layer 222b is a mixed layer, excitons may be generated within a diffusion length from a donor-acceptor interface.

According to some embodiments, the p-type organic semiconductor may be a compound that acts as an electron donor supplying electrons. For example, the p-type organic semiconductor may include boron subphthalocyanine (SubPc), copper(II) phthalocyanine (CuPc), tetraphenyldibenzoperiplantene (DBP), or any combinations thereof but is not limited thereto.

According to some embodiments, the n-type organic semiconductor may be a compound that acts as an electron acceptor receiving electrons. For example, the n-type organic semiconductor may include C60 fullerene, C70 fullerene, or any combinations thereof but is not limited thereto.

According to some embodiments, the first functional layer 221 may include at least one of a hole injection layer, a hole transport layer, or an electron blocking layer. The first functional layer 221 may have a single-layered structure or a multi-layered structure. When the first functional layer 221 has a multi-layered structure, the first functional layer 221 may include, as being each sequentially stacked in a thickness direction (z direction), a hole injection layer and a hole transport layer, a hole injection layer and an electron blocking layer, a hole transport layer and an electron blocking layer, or a hole injection layer, a hole transport layer, and an electron blocking layer. However, embodiments according to the present disclosure are not limited thereto.

According to some embodiments, the second functional layer 223 may include at least one of an electron injection layer, an electron transport layer, or a hole blocking layer. The second functional layer 223 may have a single-layered structure or a multi-layered structure. When the second functional layer 223 has a multi-layered structure, the second functional layer 223 may include, as being each sequentially stacked in a thickness direction (z direction), an electron transport layer and an electron injection layer, a hole blocking layer and an electron injection layer, a hole blocking layer and an electron transport layer, or a hole blocking layer, an electron transport layer, and an electron injection layer. However, embodiments according to the present disclosure are not limited thereto.

The opposite electrode 230 may be located on the first intermediate layer 220a and the second intermediate layer 220b. The opposite electrode 230 may include a conductive material having a relatively low work function. For example, the opposite electrode 230 may include a (semi-)transparent layer including Ag, Mg, Al, Ni, Cr, lithium (Li), calcium (Ca), or an alloy thereof. Alternatively, the opposite electrode 230 may further include a layer including ITO, IZO, ZnO, or In₂O₃, on the (semi-)transparent layer including the materials described above. According to some embodiments, the opposite electrode 230 may include Ag and Mg. The opposite electrode 230 may be integrally provided as a single body over the entire surface of the display area DA. For example, the opposite electrode 230 of the light-emitting diode ED and the opposite electrode 230 of the photo diode PD may be integrally provided as a single body.

An encapsulation layer 300 may be located on the opposite electrode 230 to cover the light-emitting diode ED and the photo diode PD. According to some embodiments, the encapsulation layer 300 may include at least one inorganic encapsulation layer and at least one organic encapsulation layer. For example, the encapsulation layer 300 may include first and second inorganic encapsulation layers 310 and 330 and an organic encapsulation layer 320 arranged therebetween.

Each of the first and second inorganic encapsulation layers 310 and 330 may include one or more inorganic insulating materials. The inorganic insulating immaterial may include silicon oxide, silicon nitride, or silicon oxynitride. The first and second inorganic encapsulation layers 310 and 330 may be formed through chemical vapor deposition.

The organic encapsulation layer 320 may further include polyethylene terephthalate, polyethylene naphthalate, polycarbonate, polyimide, polyethylene sulfonate, polyoxymethylene, polyarylate, HMDSO, acryl-based resin, or a combination thereof. The organic encapsulation layer 320 may provide a flat upper surface. Accordingly, even when an input sensing layer or the like is formed on the encapsulation layer 300 by a continuous process, a defect rate may be reduced.

The encapsulation layer 300 may cover the entire display area DA and may be arranged to extend to the peripheral area PA and cover at least a portion of the peripheral area PA.

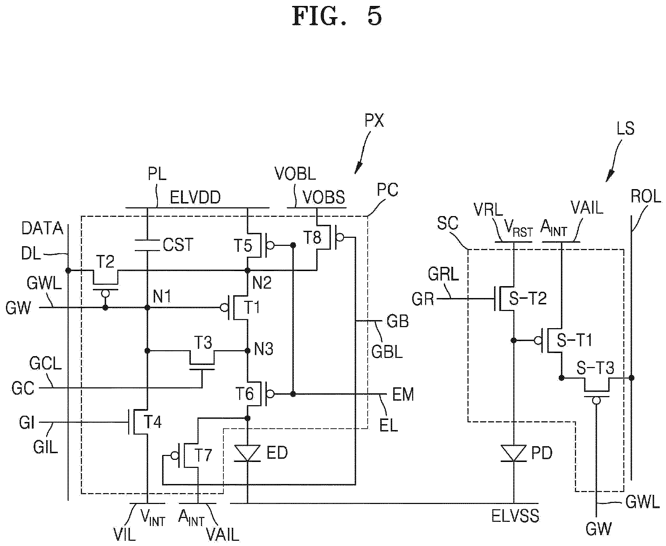

FIG. 5 is an equivalent circuit diagram schematically illustrating one pixel PX and one light detector LS included in a display apparatus 10, according to some embodiments.

The pixel PX may include a light-emitting diode ED and a pixel circuit PC connected to the light-emitting diode ED, and the light detector LS may include a photo diode PD and a sensor circuit SC connected to the photo diode PD.

The pixel circuit PC may include first to eighth transistors T1 to T8 and a storage capacitor Cst, and the sensor circuit SC may include first to third detection transistors S-T1 to S-T3.

The first transistor T1 may be a driving transistor for outputting a driving current corresponding to a data signal DATA, and the second to eighth transistors T2 to T8 may be switching transistors for transferring signals. A first terminal and a second terminal of each of the first to eighth transistors T1 to T8 and the first to third detection transistors S-T1 to S-T3 may be a source or a drain, depending on voltages of the first terminal and the second terminal thereof. For example, depending on the voltages of the first terminal and the second terminal thereof, the first terminal may be a drain and the second terminal may be a source, or the first terminal may be a source and the second terminal may be a drain.

A node connected to a gate of the first transistor T1 may be defined as a first node N1, a node to which a first terminal of the first transistor T1 is connected may be defined as a second node N2, and a node to which a second terminal of the first transistor T1 is connected may be defined as a third node N3.

The pixel PX may be connected to a first gate line GWL for transferring a first gate signal GW, a second gate line GCL for transferring a second gate signal GC, a third gate line GIL for transferring a third gate signal GI, a fourth gate line EL for transferring a fourth gate signal EM, and a fifth gate line GBL for transferring a fifth gate signal GB. Because emission of the pixel PX is controlled by the fourth gate signal EM, the fourth gate signal EM may be defined as an emission control signal and the fourth gate line EL may be defined as an emission control line.

In addition, the pixel PX may be connected to a driving voltage line PL (second voltage line) for transferring a driving voltage ELVDD, a reference voltage line VOBL for transferring a reference voltage VOBS, a data line DL for transferring the data signal DATA, a first initialization voltage line VIL for transferring a first initialization voltage V_{INT}, and a second initialization voltage line VAIL for transferring a second initialization voltage A_{INT}.

The gate of the first transistor T1 (driving transistor) may be connected to the first node N1, the first terminal of the first transistor T1 may be connected to the second node N2, and the second terminal of the first transistor T1 may be connected to the third node N3. The first terminal of the first transistor T1 may be connected to the driving voltage line PL via the fifth transistor T5, and the second terminal of the first transistor T1 may be connected to a pixel electrode (first electrode) of the light-emitting diode ED via the sixth transistor T6. The first transistor T1 may receive the data signal DATA in response to a switching operation of the second transistor T2 and control the amount of driving current flowing in the light-emitting diode ED.

The second transistor T2 (data write transistor) may be connected between the data line DL and the second node N2. The secondo transistor T2 may include a gate connected to the first gate line GWL, a first terminal connected to the data line DL, and a second terminal connected to the second node N2. The second transistor T2 may be turned on by the first gate signal GW received via the first gate line GWL and may electrically connect the data line DL to the second node N2 and transfer the data signal DATA received via the data line DL to the second node N2.

The third transistor T3 (compensation transistor) may be connected between the first node N1 and the third node N3. The third transistor T3 may include a gate connected to the second gate line GCL, a first terminal connected to the first node N1, and a second terminal connected to the third node N3. The third transistor T3 may be turned on by the second gate signal GC received via the second gate line GCL, to diode-connect the first transistor T1.

The fourth transistor T4 (first initialization transistor) may be connected between the first node N1 and the first initialization voltage line VIL. The fourth transistor T4 may include a gate connected to the third gate line GIL, a first terminal connected to the first node N1, and a second terminal connected to the first initialization voltage line VIL. The fourth transistor T4 may be turned on by the third gate signal GI received via the third gate line GIL and may transfer the first initialization voltage V_{INT} received via the first initialization voltage line VIL to the first node N1.

The fifth transistor T5 (first emission control transistor) may be connected between the driving voltage line PL and the second node N2. The fifth transistor T5 may include a gate connected to the fourth gate line EL, a first terminal connected to the driving voltage line PL, and a second terminal connected to the second node N2. The fifth transistor T5 may be turned on or off in response to the fourth gate signal EM received via the fourth gate line EL.

The sixth transistor T6 (second emission control transistor) may be connected between the third node N3 and the light-emitting diode ED. The sixth transistor T6 may include a gate connected to the fourth gate line EL, a first terminal connected to the third node N3, and a second terminal connected to the light-emitting diode ED. The sixth transistor T6 may be turned on or off in response to the fourth gate signal EM received via the fourth gate line EL.

The seventh transistor T7 (second initialization transistor) may be connected between the light-emitting diode ED and the second initialization voltage line VAIL. The seventh transistor T7 may include a gate connected to the fifth gate line GBL, a first terminal connected to the light-emitting diode ED, and a second terminal connected to the second initialization voltage line VAIL. The seventh transistor T7 may be turned on by the fifth gate signal GB received via the fifth gate line GBL and may transfer the second initialization voltage A_{INT} received via the second initialization voltage line VAIL to the pixel electrode of the light-emitting diode ED.

The eighth transistor T8 (third initialization transistor) may be connected between the reference voltage line VOBL and the second node N2. The eighth transistor T8 may include a gate connected to the fifth gate line GBL, a first terminal connected to the reference voltage line VOBL, and a second terminal connected to the second node N2. The eighth transistor T8 may be turned on by the fifth gate signal GB received via the fifth gate line GBL and may transfer the reference voltage VOBS received via the reference voltage line VOBL to the second node N2.

The storage capacitor Cst may be connected between the driving voltage line PL and the first node N1. A first electrode of the storage capacitor Cst may be connected to the first node N1, and a second electrode may be connected to the driving voltage line PL. The storage capacitor Cst may store a charge corresponding to the voltage difference between the driving voltage ELVDD and a voltage of the gate of the first transistor T1.

The light-emitting diode ED may be connected to the first transistor T1 via the sixth transistor T6. The light-emitting diode ED may include the pixel electrode (first electrode) (i.e., the pixel electrode 210a in FIG. 4) connected to the second terminal of the sixth transistor T6, and an opposite electrode (second electrode) (i.e., the opposite electrode 230 in FIG. 4) facing the pixel electrode, and the opposite electrode may receive a common voltage ELVSS. As described with reference to FIG. 4, the opposite electrode may be a common electrode integrally provided across a plurality of pixels PX and a plurality of light detectors LS.

The light detector LS may be connected to the first gate line GWL for transferring the first gate signal GW, and a sixth gate line GRL for transferring a sixth gate signal GR.

In addition, the light detector LS may be connected to a reset voltage line VRL for transferring a reset voltage V_{RST}, the second initialization voltage line VAIL for transferring the second initialization voltage A_{INT}, and a read-out line ROL.

The first detection transistor S-T1 may be connected between the second initialization voltage line VAIL and the third detection transistor S-T3. The first detection transistor S-T1 may include a gate connected to a detection electrode (i.e., the detection electrode 210b in FIG. 4) of the photo diode PD, a first terminal connected to the second initialization voltage line VAIL, and a second terminal connected to the read-out line ROL via the third detection transistor S-T3. The first detection transistor S-T1 may be turned on by a light detection signal of the photo diode PD and may transfer the second initialization voltage A_{INT} received via the second initialization voltage line VAIL to the read-out line ROL via the third detection transistor S-T3.

The second detection transistor S-T2 may be connected between the reset voltage line VRL and the photo diode PD. The second detection transistor S-T2 may include a gate connected to the sixth gate line GRL, a first terminal connected to the reset voltage line VRL, and a second terminal connected to the gate of the first detection transistor S-T1. The second detection transistor S-T2 may be turned on by the sixth gate signal GR received via the sixth gate line GRL and may transfer the reset voltage V_{RST} received via the reset voltage line VRL to the gate of the first detection transistor S-T1, to initialize the gate of the first detection transistor S-T1.

The third detection transistor S-T3 may be connected between the first detection transistor S-T1 and the read-out line ROL. The third detection transistor S-T3 may include a gate connected to the first gate line GWL, a first terminal connected to the first detection transistor S-T1, and a second terminal connected to the read-out line ROL. The third detection transistor S-T3 may be turned on by the first gate signal GW received via the first gate line GWL and may transfer, to the read-out line ROL, the second initialization voltage A_{INT} received via the first detection transistor S-T1 from the second initialization voltage line VAIL.

The photo diode PD may include a detection electrode (first electrode) (i.e., the detection electrode 210b in FIG. 4) connected to the gate of the first detection transistor S-T1, and an opposite electrode (second electrode) (i.e., the opposite electrode 230 in FIG. 4) facing the detection electrode, and the opposite electrode may receive the common voltage ELVSS. The opposite electrode may be a common electrode integrally provided across the plurality of pixels PX and the plurality of light detectors LS.

With respect to FIG. 5, a case in which the pixel circuit PC includes eight transistors and one capacitor, and the sensor circuit SC includes three transistors is described. However, one or more embodiments are not limited thereto.

Some of the first to eighth transistors T1 to T8 and the first to third detection transistors S-T1 to S-T3 may be n-type oxide thin-film transistors, and the other transistors may be p-type silicon thin-film transistors. According to some embodiments, the third transistor T3, the fourth transistor T4, and the second detection transistors S-T2 may be n-type oxide thin-film transistors, and the other transistors may be p-type silicon thin-film transistors.

An oxide thin-film transistor may be a low temperature polycrystalline oxide (LTPO), in which an active pattern (semiconductor layer) includes an oxide. However, this is only an example, and n-type transistors are not limited thereto. For example, an active pattern (semiconductor layer) included in the n-type transistor may include an inorganic material semiconductor (e.g., amorphous silicon, polysilicon, etc.) or an organic material semiconductor. The silicon thin-film transistor may be an LTPS thin-film transistor, in which an active pattern (semiconductor layer) includes amorphous silicon, polysilicon, etc.

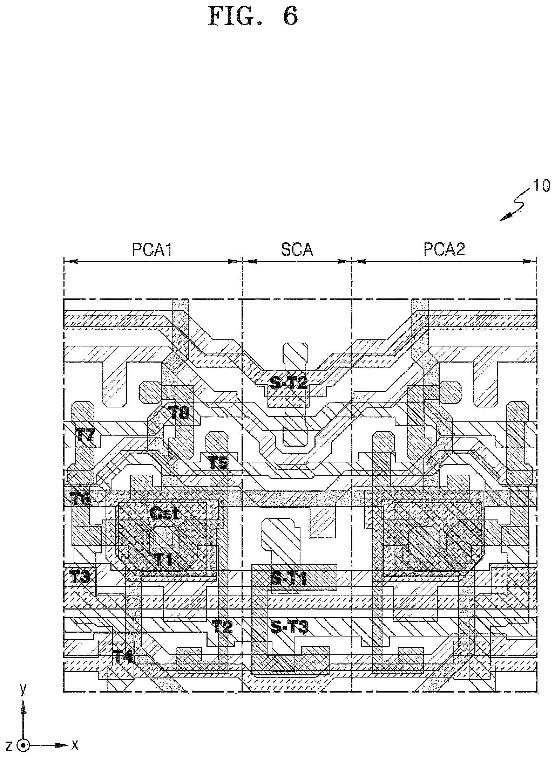

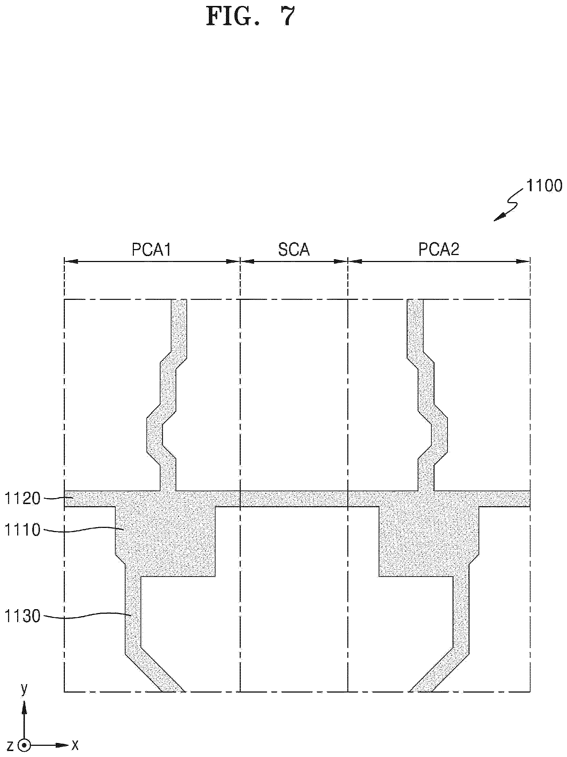

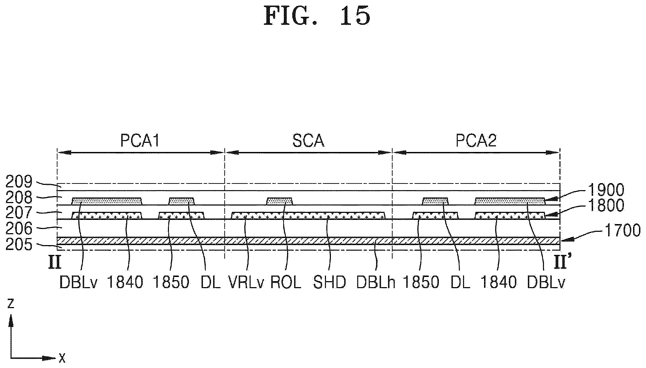

FIG. 6 is a layout diagram schematically illustrating a display apparatus 10 according to some embodiments, and FIGS. 7 to 14 are level-by-level layout diagrams schematically illustrating a display apparatus 10 according to some embodiments. FIG. 15 is a cross-sectional view schematically illustrating a display apparatus 10 according to some embodiments.

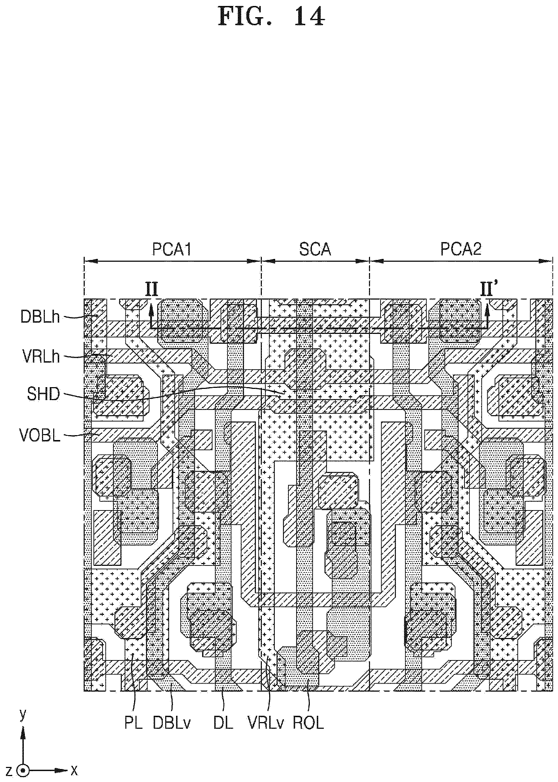

FIG. 6 schematically shows locations of transistors T1 to T8, storage capacitors Cst, and detection transistors S-T1 to S-T3 in the pixels PX and light detector LS included in the display apparatus 10 according to some embodiments. FIG. 14 shows only a first electrode layer 1700, a second electrode layer 1800, and a third electrode layer 1900 to explain the arrangement relationship of connection lines DBLv and DBLh, a read-out line ROL, and a second reset voltage line VRLv (first voltage line). FIG. 15 is a cross-sectional view schematically illustrating a cross-section taken along line II-II' of the display apparatus 10 of FIG. 14.

As shown in FIGS. 6 to 14, the display apparatus 10 may include a first pixel circuit arranged in a first pixel circuit area PCA1, a second pixel circuit arranged in a second pixel circuit area PCA2, and a sensor circuit arranged in a sensor circuit area SCA. The sensor circuit area SCA may be between the first pixel circuit area PCA1 and the second pixel circuit area PCA2 adjacent to each other.

The first pixel circuit and the second pixel circuit may have a linearly symmetrical shape with the sensor circuit therebetween. That is, components of the second pixel circuit corresponding to components of the first pixel circuit may be arranged symmetrically about an imaginary line with the sensor circuit therebetween, the imaginary line bisecting the sensor circuit area SCA and extending in a second direction (y direction). For convenience of description, the description will be made based on the first pixel circuit arranged in the first pixel circuit area PCA1, but these components may also be arranged in the second pixel circuit arranged in the second pixel circuit area PCA2.

First to eighth transistors T1 to T8 may be arranged in the first pixel circuit area PCA1, and first to third detection transistors S-T1 to S-T3 may be arranged in the sensor circuit area SCA.

Referring to FIG. 7, a lower metal layer 1100 may be located on the substrate 100 (see FIG. 1).

The lower metal layer 1100 may include a low-resistance metal material. For example, the lower metal layer 1100 may include a conductive material including Mo, Al, Cu, Ti, or the like and may include a layer or layers including the aforementioned material.

The lower metal layer 1100 may include a lower metal pattern 1110. The lower metal pattern 1110 may overlap an active region of the first transistor T1, and thus may prevent or reduce external light from entering the active region of the first transistor T1.

The lower metal pattern 1110 may be connected to a first lower metal line 1120 extending in a first direction (x direction) and a second lower metal line 1130 extending in a second direction (y direction). The first lower metal line 1120 may connect lower metal patterns 1110 of pixel circuits PC arranged in the same row in the first direction (x direction), and the second lower metal line 1130 may connect lower metal patterns 1110 of pixel circuits PC arranged in the same column in the second direction (y direction).

According to some embodiments, the lower metal pattern 1110 may be provided integrally with the first lower metal line 1120 and the second lower metal line 1130. The first lower metal line 1120 and the second lower metal line 1130 may cross each other to form a mesh structure in the display area DA (see FIG. 1).

According to some embodiments, the lower metal pattern 1110, the first lower metal line 1120, and the second lower metal line 1130 may be connected to a constant voltage line having no voltage fluctuation during one frame. For example, the lower metal pattern 1110, the first lower metal line 1120, and the second lower metal line 1130 may be electrically connected to the driving voltage line PL so that the driving voltage ELVDD may be applied thereto.

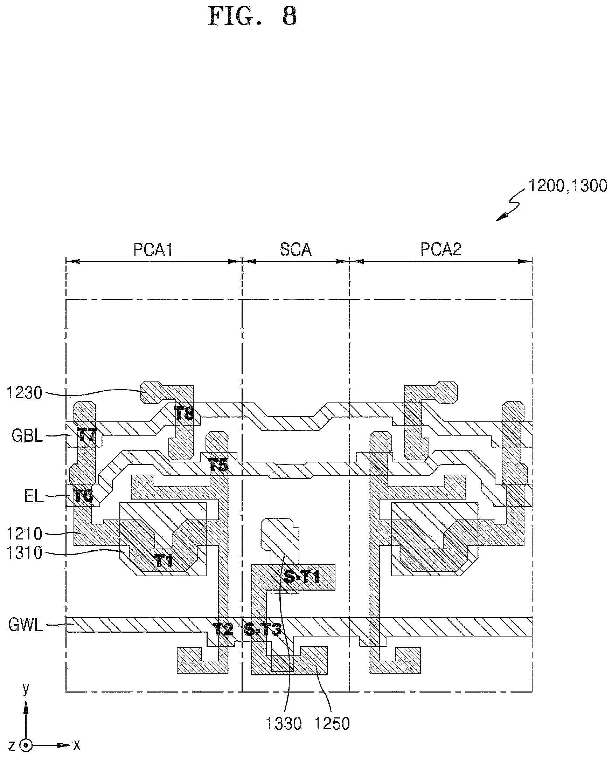

Referring to FIG. 8, a first semiconductor layer 1200 may be located on an insulating layer covering the lower metal layer 1100, and a first conductive layer 1300 may be located on an insulating layer covering the first semiconductor layer 1200. FIG. 8 illustrates the first semiconductor layer 1200 and the first conductive layer 1300 to explain the locations of the transistors T1, T2, T5, T6, T7, and T8 and the detection transistors S-T1 and S-T3.

The first semiconductor layer 1200 may include a silicon semiconductor. For example, the first semiconductor layer 1200 may include amorphous silicon or polysilicon. The first semiconductor layer 1200 may include polysilicon crystallized at a low temperature. If necessary, ions may be implanted into at least a portion of the first semiconductor layer 1200.

The first semiconductor layer 1200 may include a first semiconductor pattern 1210 and a second semiconductor pattern 1230 arranged in the first pixel circuit area PCA1 and a third semiconductor pattern 1250 arranged in the sensor circuit area SCA.

The first transistor T1, the second transistor T2, the fifth transistor T5, the sixth transistor T6, and the seventh transistor T7 may be located along the first semiconductor pattern 1210. The eighth transistor T8 may be located on the second semiconductor pattern 1230. The first detection transistor S-T1 and the third detection transistor S-T3 may be located along the third semiconductor pattern 1250.

The first conductive layer 1300 may include a low-resistance metal material. For example, the first conductive layer 1300 may include a conductive material including Mo, Al, Cu, Ti, or the like and may include a layer or layers including the aforementioned material.

The first conductive layer 1300 may include a first metal pattern 1310, a second metal pattern 1330, a first gate line GWL, a fourth gate line EL, and a fifth gate line GBL.

The first metal pattern 1310 may be arranged in the first pixel circuit area PCA1 and may have an isolated shape. The first metal pattern 1310 may overlap the first semiconductor pattern 1210. The first metal pattern 1310 may be a gate electrode GE of the first transistor T1. A portion of the first semiconductor pattern 1210 overlapping the first metal pattern 1310 may be referred to as an active region of the first transistor T1. As described with reference to FIG. 4, the gate electrode of the first transistor T1 may be a lower electrode (i.e., the first electrode CE1) of the storage capacitor Cst.

The second metal pattern 1330 may be arranged in the sensor circuit area SCA and may have an isolated shape. The second metal pattern 1330 may overlap the third semiconductor pattern 1250. The second metal pattern 1330 may be a gate electrode of the first detection transistor S-T1. A portion of the third semiconductor pattern 1250 overlapping the second metal pattern 1330 may be referred to as an active region of the first detection transistor S-T1.

The first gate line GWL may extend in the first direction (x direction) to cross the first pixel circuit area PCA1, the sensor circuit area SCA, and the second pixel circuit area PCA2. The first gate line GWL may overlap the first semiconductor pattern 1210 and the third semiconductor pattern 1250. The first gate line GWL may be the gate electrode of the second transistor T2 and the gate electrodes of the third detection transistors S-T3. A portion of the first semiconductor pattern 1210 overlapping the first gate line GWL may be referred to as an active region of the second transistor T2, and a portion of the third semiconductor pattern 1250 overlapping the first gate line GWL may be referred to as an active region of the third detection transistor S-T3. The first gate signal GW (see FIG. 5) may be applied to pixels PX and light detectors LS through the first gate line GWL.

The fourth gate line EL may extend in the first direction (x direction) to cross the first pixel circuit area PCA1, the sensor circuit area SCA, and the second pixel circuit area PCA2. The fourth gate line EL may overlap the first semiconductor pattern 1210. The fourth gate line EL may be the gate electrode of the fifth transistor T5 and the gate electrode of the sixth transistor T6. Portions of the first semiconductor pattern 1210 overlapping the fourth gate line EL may be referred to as an active region of the fifth transistor T5 and an active region of the sixth transistor T6, respectively. The fourth gate signal EM (see FIG. 5) may be applied to the pixels PX through the fourth gate line EL.

The fifth gate line GBL may extend in the first direction (x direction) to cross the first pixel circuit area PCA1, the sensor circuit area SCA, and the second pixel circuit area PCA2. The fifth gate line GBL may overlap the first semiconductor pattern 1210 and the second semiconductor pattern 1230. The fifth gate line GBL may be the gate electrode of the seventh transistor T7 and the gate electrode of the eighth transistor T8. A portion of the first semiconductor pattern 1210 overlapping the fifth gate line GBL may be referred to as an active region of the seventh transistor T7, and a portion of the second semiconductor pattern 1230 overlapping the fifth gate line GBL may be referred to as an active region of the eighth transistor T8. The fifth gate signal GB (see FIG. 5) may be applied to the pixels PX through the fifth gate line GBL.

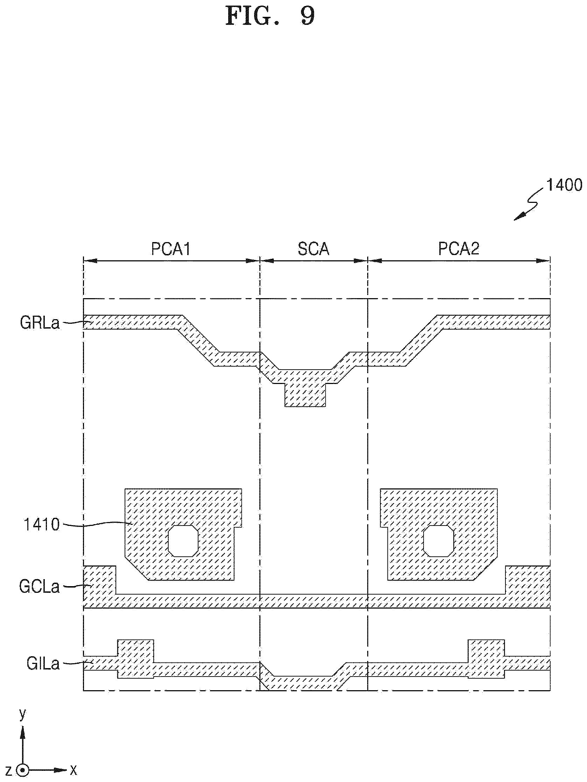

Referring to FIG. 9, a second conductive layer 1400 may be located on an insulating layer covering the first conductive layer 1300. The second conductive layer 1400 may include a low-resistance metal material. The second conductive layer 1400 may include a conductive material including Mo, Al, Cu, Ti, or the like and may include a layer or layers including the aforementioned material.

The second conductive layer 1400 may include a third metal pattern 1410, a 2nd-1 gate line GCLa, a 3rd-1 gate line GILa, and a 6th-1 gate line GRLa.

The third metal pattern 1410 may be arranged in the first pixel circuit area PCA1 and may have an isolated shape. The third metal pattern 1410 may overlap the first metal pattern 1310. As described with reference to FIG. 4, the third metal pattern 1410 may be an upper electrode (i.e., the second electrode CE2) of the storage capacitor Cst.

The 2nd-1 gate line GCLa may extend in the first direction (x direction) to cross the first pixel circuit area PCA1, the sensor circuit area SCA, and the second pixel circuit area PCA2. The 2nd-1 gate line GCLa may correspond to the second gate line GCL of FIG. 5. The 2nd-1 gate line GCLa may overlap a fourth semiconductor pattern 1510 of a second semiconductor layer 1500 to be described below. The 2nd-1 gate line GCLa may be a lower gate electrode of the third transistor T3. A portion of the fourth semiconductor pattern 1510 overlapping the 2nd-1 gate line GCLa may be referred to as an active region of the third transistor T3. The second gate signal GC (see FIG. 5) may be applied to the pixels PX through the 2nd-1 gate line GCLa.

The 3rd-1 gate line GILa may extend in the first direction (x direction) to cross the first pixel circuit area PCA1, the sensor circuit area SCA, and the second pixel circuit area PCA2. The 3rd-1 gate line GILa may correspond to the third gate line GIL of FIG. 5. The 3rd-1 gate line GILa may overlap the fourth semiconductor pattern 1510 of the second semiconductor layer 1500. The 3rd-1 gate line GILa may be a lower gate electrode of the fourth transistor T4. A portion of the fourth semiconductor pattern 1510 overlapping the 3rd-1 gate line GILa may be referred to as an active region of the fourth transistor T4. The third gate signal GI (see FIG. 5) may be applied to the pixels PX through the 3rd-1 gate line GILa.

The 6th-1 gate line GRLa may extend in the first direction (x direction) to cross the first pixel circuit area PCA1, the sensor circuit area SCA, and the second pixel circuit area PCA2. The 6th-1 gate line GRLa may correspond to the sixth gate line GRL of FIG. 5. The 6th-1 gate line GRLa may overlap the fifth semiconductor pattern 1530 of the second semiconductor layer 1500. The 6th-1 gate line GRLa may be a lower gate electrode of the second detection transistor S-T2. A portion of the fifth semiconductor pattern 1530 overlapping the 6th-1 gate line GRLa may be referred to as an active region of the second detection transistor S-T2. The sixth gate signal GR (see FIG. 5) may be applied to the light detectors LS through the 6th-1 gate line GRLa.

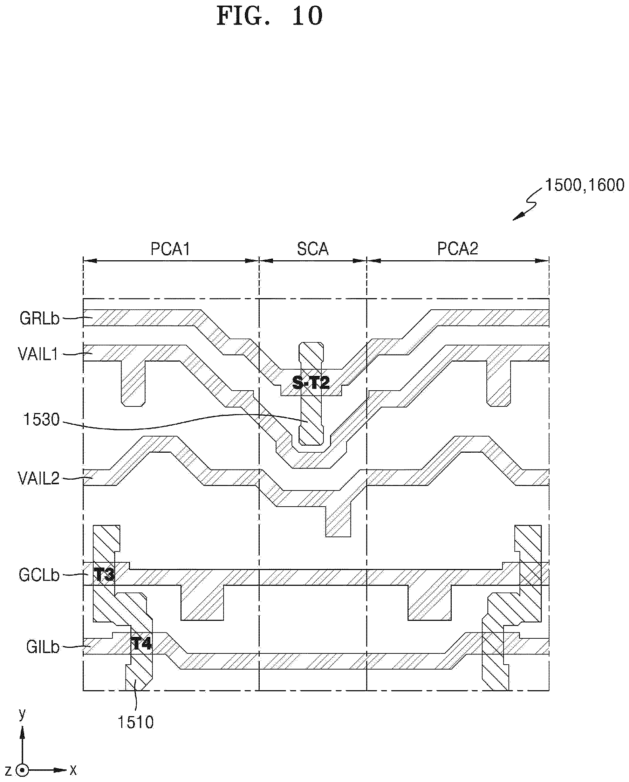

Each of the 2nd-1 gate line GCLa, the 3rd-1 gate line GILa, and the 6th-1 gate line GRLa may be located under the second semiconductor layer 1500 to be described below with reference to FIG. 10 and function as a gate electrode of a corresponding transistor, and may also function as a lower protection metal to protect the active region of the third transistor T3, the active region of the fourth transistor T4, and the active region of the second detection transistor S-T2.

Referring to FIG. 10, the second semiconductor layer 1500 may be located on an insulating layer covering the second conductive layer 1400, and a third conductive layer 1600 may be located on an insulating layer covering the second semiconductor layer 1500. FIG. 10 shows the second semiconductor layer 1500 and the third conductive layer 1600 to explain the locations of the third transistor T3, the fourth transistor T4, and the second detection transistor S-T2.

The second semiconductor layer 1500 may include an oxide semiconductor. For example, the second semiconductor layer 1500 may include an oxide of at least one material selected from the group consisting of indium (In), gallium (Ga), stannum (Sn), zirconium (Zr), vanadium (V), hafnium (Hf), cadmium (Cd), germanium (Ge), chromium (Cr), titanium (Ti), aluminum (Al), cesium (Cs), cerium (Ce), and zinc (Zn). The second semiconductor layer 1500 may be an InSnZnO (ITZO) semiconductor layer, an InGaZnO (IGZO) semiconductor layer, or the like. If necessary, at least a portion of the second semiconductor layer 1500 may be subjected to a conductive process by plasma treatment or the like.

The second semiconductor layer 1500 may include a fourth semiconductor pattern 1510 arranged in the first pixel circuit area PCA1 and a fifth semiconductor pattern 1530 arranged in the sensor circuit area SCA.

The third transistor T3 and the fourth transistor T4 may be located along the fourth semiconductor pattern 1510. The second detection transistor S-T2 may be located on the fifth semiconductor pattern 1530.

The third conductive layer 1600 may include a low-resistance metal material. For example, the third conductive layer 1600 may include a conductive material including Mo, Al, Cu, Ti, or the like and may include a layer or layers including the aforementioned material.

The third conductive layer 1600 may include a 2nd-2 gate line GCLb, a 3rd-2 gate line GILb, a 6th-2 gate line GRLb, a 2nd-1 initialization voltage line VAIL1, and a 2nd-2 initialization voltage line VAIL2. Each of the 2nd-2 gate line GCLb, the 3rd-2 gate line GILb, the 6th-2 gate line GRLb, the 2nd-1 initialization voltage line VAIL1, and the 2nd-2 initialization voltage line VAIL2 may extend in the first direction (x direction) to cross the first pixel circuit area PCA1, the sensor circuit area SCA, and the second pixel circuit area PCA2.

The 2nd-2 gate line GCLb may overlap the fourth semiconductor pattern 1510 of the second semiconductor layer 1500. The 2nd-2 gate line GCLb may be an upper gate electrode of the third transistor T3. The 2nd-2 gate line GCLb may be electrically connected to the 2nd-1 gate line GCLa through a contact hole formed in an insulating layer between the 2nd-2 gate line GCLb and the 2nd-1 gate line GCLa. The contact hole may be located in the display area DA or may be located in the peripheral area PA. The 2nd-2 gate line GCLb may correspond to the second gate line GCL of FIG. 5. Accordingly, the second gate signal GC (see FIG. 5) may be applied to the pixels PX through the 2nd-1 gate line GCLa and/or the 2nd-2 gate line GCLb.

The 3rd-2 gate line GILb may overlap the fourth semiconductor pattern 1510 of the second semiconductor layer 1500. The 3rd-2 gate line GILb may be an upper gate electrode of the fourth transistor T4. The 3rd-2 gate line GILb may be electrically connected to the 3rd-1 gate line GILa through a contact hole formed in an insulating layer between the 3rd-2 gate line GILb and the 3rd-1 gate line GILa. The contact hole may be located in the display area DA or may be located in the peripheral area PA. The 3rd-2 gate line GILb may correspond to the third gate line GIL of FIG. 5. Accordingly, the third gate signal GI (see FIG. 5) may be applied to the pixels PX through the 3rd-1 gate line GILa and/or the 3rd-2 gate line GILb.

The 6th-2 gate line GRLb may overlap the fifth semiconductor pattern 1530 of the second semiconductor layer 1500. The 6th-2 gate line GRLb may be an upper gate electrode of the second detection transistor S-T2. The 6th-2 gate line GRLb may be electrically connected to the 6th-1 gate line GRLa through a contact hole formed in an insulating layer between the 6th-2 gate line GRLb and the 6th-1 gate line GRLa. The contact hole may be located in the display area DA or may be located in the peripheral area PA. The 6th-2 gate line GRLb may correspond to the sixth gate line GRL of FIG. 5. Accordingly, the sixth gate signal GR (see FIG. 5) may be applied to the light detectors LS through the 6th-1 gate line GRLa and/or the 6th-2 gate line GRLb.

The 2nd-1 initialization voltage line VAIL1 and the 2nd-2 initialization voltage line VAIL2 may correspond to the second initialization voltage line VAIL of FIG. 5. According to some embodiments, some of the pixels PX may be electrically connected to the 2nd-1 initialization voltage line VAIL1 and receive a 2nd-1 initialization voltage, and the other pixes PX and the light detectors LS may be electrically connected to the 2nd-1 initialization voltage line VAIL1 and receive a 2nd-2 initialization voltage. The 2nd-1 initialization voltage and the 2nd-2 initialization voltage may have different magnitudes and may each correspond to the second initialization voltage A_{INT} of FIG. 5.

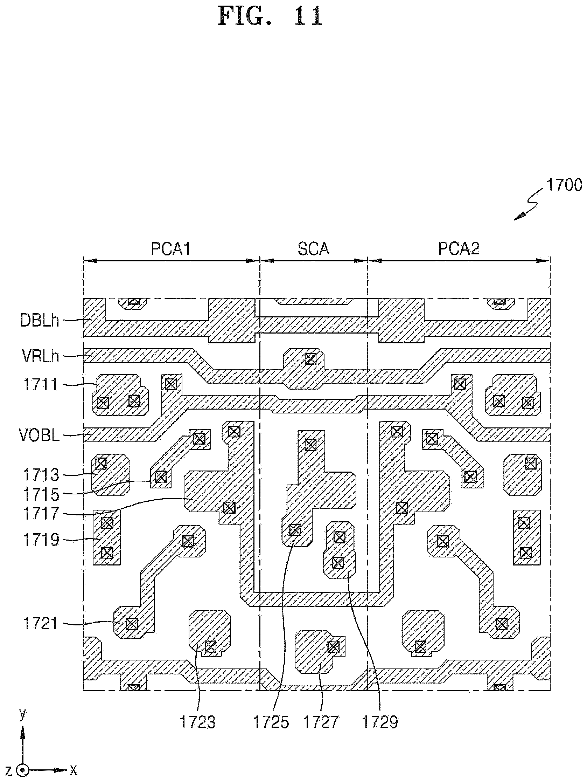

Referring to FIG. 11, a first electrode layer 1700 may be located on an insulating layer covering the third conductive layer 1600. The first electrode layer 1700 may include a low-resistance metal material. For example, the first electrode layer 1700 may include a conductive material including Mo, Al, Cu, Ti, or the like and may include a layer or layers including the aforementioned material.

The first electrode layer 1700 may include first to tenth electrode patterns 1711 to 1729, a horizontal connection line DBLh, a first reset voltage line VRLh, and a reference voltage line VOBL.

The first to third electrode patterns 1711 to 1715 and the fifth to seventh electrode patterns 1719 to 1723 may be arranged in the first pixel circuit area PCA1 and may have an isolated shape. The fourth electrode pattern 1717 may pass through the sensor circuit area SCA and may be arranged in the first pixel circuit area PCA1 and the second pixel circuit area PCA2.

The first electrode pattern 1711 may be connected to the first semiconductor pattern 1210 and the 2nd-1 initialization voltage line VAIL1 through contact holes. A second terminal of the seventh transistor T7 may be electrically connected to the 2nd-1 initialization voltage line VAIL1 through the first electrode pattern 1711.

The second electrode pattern 1713 may be connected to the first semiconductor pattern 1210 through a contact hole. A second terminal of the sixth transistor T6 and a pixel electrode of the light-emitting diode ED (see FIG. 5) may be electrically connected to each other through the second electrode pattern 1713.

The third electrode pattern 1715 may be connected to the first semiconductor pattern 1210 and the second semiconductor pattern 1230 through contact holes. A second terminal of the fifth transistor T5 and a second terminal of the eighth transistor T8 may be electrically connected to each other through the third electrode pattern 1715.

The fourth electrode pattern 1717 may be connected to the first semiconductor pattern 1210 and the third metal pattern 1410 of the second conductive layer 1400 through contact holes. Through the fourth electrode pattern 1717, a first terminal of the fifth transistor T5 and the upper electrode of the storage capacitor Cst may be electrically connected to a driving voltage line PL to be described below.

The fifth electrode pattern 1719 may be connected to the first semiconductor pattern 1210 and the fourth semiconductor pattern 1510 through contact holes. A second terminal of the third transistor T3 and a first terminal of the sixth transistor T6 may be electrically connected to each other through the fifth electrode pattern 1719.

The sixth electrode pattern 1721 may be connected to the fourth semiconductor pattern 1510 and the first metal pattern 1310 of the first conductive layer 1300 through contact holes. A gate electrode of the first transistor T1, a first terminal of the third transistor T3, and a first terminal of the fourth transistor T4 may be electrically connected to one another through the sixth electrode pattern 1721.

The seventh electrode pattern 1723 may be connected to the first semiconductor pattern 1210 through a contact hole. A first terminal of the second transistor T2 and a data line DL to be described below may be electrically connected to each other through the seventh electrode pattern 1723.

The eighth electrode pattern 1725, the ninth electrode pattern 1727, and the tenth electrode pattern 1729 may be arranged in the sensor circuit area SCA and may have an isolated shape.

The eighth electrode pattern 1725 may be connected to the fifth semiconductor pattern 1530 and the second metal pattern 1330 of the first conductive layer 1300 through contact holes. A gate electrode of the first detection transistor S-T1 and a second terminal of the second detection transistor S-T2 may be electrically connected to each other through the eighth electrode pattern 1725.

The ninth electrode pattern 1727 may be connected to the third semiconductor pattern 1250 through a contact hole. Through the ninth electrode pattern 1727, a second terminal of the third detection transistor S-T3 may be electrically connected to a read-out line ROL to be described below.

The tenth electrode pattern 1729 may be electrically connected to the 2nd-2 initialization voltage line VAIL2 and the second metal pattern 1330 through contact holes. A first terminal of the first detection transistor S-T1 and the 2nd-2 initialization voltage line VAIL2 may be electrically connected to each other through the tenth electrode pattern 1729.

Each of the horizontal connection line DBLh, the first reset voltage line VRLh, and the reference voltage line VOBL may extend in the first direction (x direction) to cross the first pixel circuit area PCA1, the sensor circuit area SCA, and the second pixel circuit area PCA2.

The horizontal connection line DBLh may correspond to any one of the first connection lines described with reference to FIG. 2. The horizontal connection line DBLh may be electrically connected to the corresponding data line DL through a contact hole.

The first reset voltage line VRLh may be connected to the fifth semiconductor pattern 1530 through a contact hole. The first reset voltage line VRLh may correspond to the reset voltage line VRL described with reference to FIG. 5. A reset voltage V_{RST} (see FIG. 5) may be applied to a first terminal of the second detection transistor S-T2 through the first reset voltage line VRLh.

The reference voltage line VOBL may be connected to the second semiconductor pattern 1230 through a contact hole. A reference voltage VOBS (see FIG. 5) may be applied to a first terminal of the eighth transistor T8 through the reference voltage line VOBL.

According to some embodiments, each of the insulating layers arranged between the lower metal layer 1100 and the first semiconductor layer 1200, between the first semiconductor layer 1200 and the first conductive layer 1300, between the first conductive layer 1300 and the second conductive layer 1400, between the second conductive layer 1400 and the second semiconductor layer 1500, between the second semiconductor layer 1500 and the third conductive layer 1600, and between the third conductive layer 1600 and the first electrode layer 1700 may include a layer or layers including an inorganic insulating material.

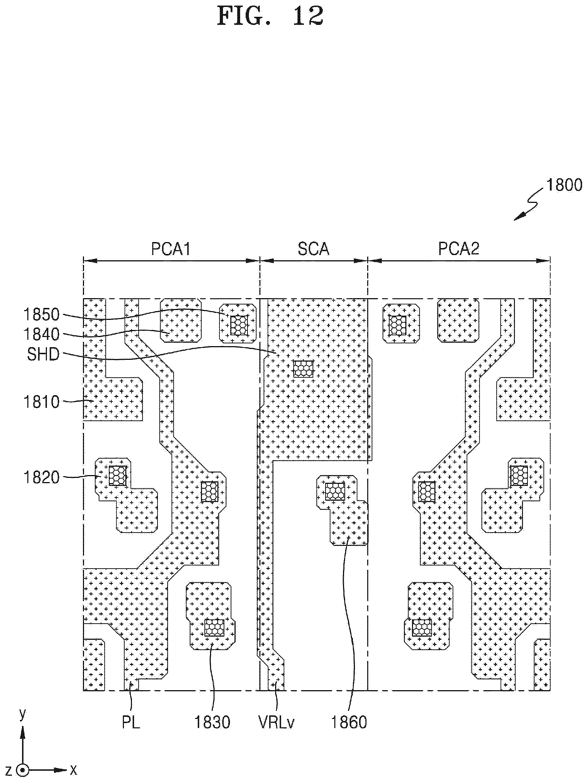

Referring to FIG. 12, a second electrode layer 1800 may be located on an insulating layer covering the first electrode layer 1700. The second electrode layer 1800 may include a low-resistance metal material. For example, the second electrode layer 1800 may include a conductive material including Mo, Al, Cu, Ti, or the like and may include a layer or layers including the aforementioned material.

The second electrode layer 1800 may include eleventh to sixteenth electrode patterns 1810 to 1860, a driving voltage line PL, and a second reset voltage line VRLv.

The eleventh to fifteenth electrode patterns 1810 to 1850 may be arranged in the first pixel circuit area PCA1 and may have an isolated shape.

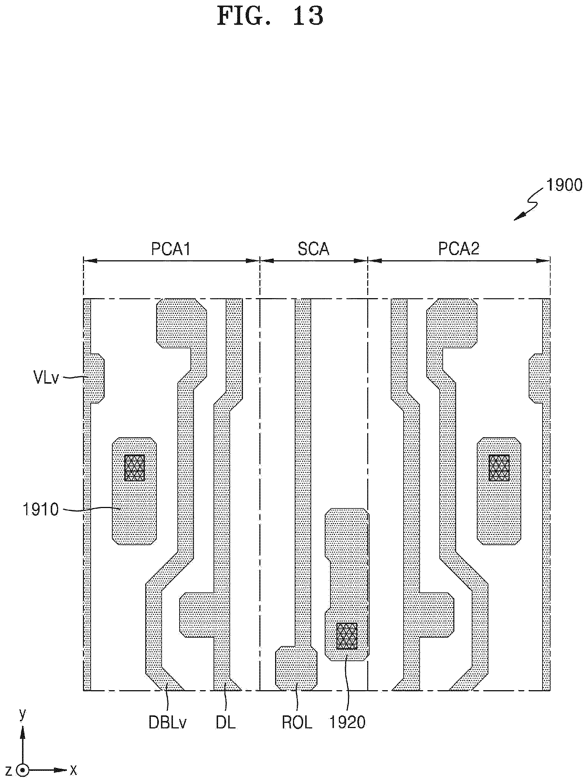

The eleventh electrode pattern 1810 may connect the first initialization voltage line VIL or the 2nd-1 initialization voltage line VAIL1 to a vertical voltage line VLv (see FIG. 13) through a contact hole.

The twelfth electrode pattern 1820 may be connected to the second electrode pattern 1713 of the first electrode layer 1700 through a contact hole.

The thirteenth electrode pattern 1830 may be connected to the seventh electrode pattern 1723 of the first electrode layer 1700 through a contact hole.

The fifteenth electrode pattern 1850 may be connected to the horizontal connection line DBLh of the first electrode layer 1700 through a contact hole.

The sixteenth electrode pattern 1860 may be arranged in the sensor circuit area SCA and may have an isolated shape. The sixteenth electrode pattern 1860 may be connected to the eighth electrode pattern 1725 of the first electrode layer 1700 through a contact hole.

The driving voltage line PL (second voltage line) may extend in the second direction (y direction) to cross the first pixel circuit area PCA1. The second reset voltage line VRLv may extend in the second direction (y direction) to cross the sensor circuit area SCA.

The driving voltage line PL may be connected to the fourth electrode pattern 1717 of the first electrode layer 1700 through a contact hole. The driving voltage line PL may apply a driving voltage ELVDD (see FIG. 5) to the first terminal of the fifth transistor T5 and the upper electrode of the storage capacitor Cst through the fourth electrode pattern 1717.

According to some embodiments, the driving voltage line PL may be arranged to overlap the third and fourth transistors T3 and T4. The driving voltage line PL may function as an upper protection metal to protect the active region of the third transistor T3 and the active region of the fourth transistor T4.

The second reset voltage line VRLv (first voltage line) may be connected to the first reset voltage line VRLh through a contact hole. The first reset voltage line VRLh and the second reset voltage line VRLv may cross each other to form a mesh structure. The second reset voltage line VRLv may correspond to the reset voltage line VRL of FIG. 5. Accordingly, the reset voltage V_{RST} (see FIG. 5) may be applied to the light detectors LS through the first reset voltage line VRLh and the second reset voltage line VRLv.

According to some embodiments, the second reset voltage line VRLv may include a shielding portion SHD protruding from the second reset voltage line VRLv in the first direction (x direction). The shielding portion SHD may overlap the horizontal connection line DBLh of the first electrode layer 1700. According to some embodiments, in a plan view, the shielding portion SHD may cover a portion of the horizontal connection line DBLh passing through the sensor circuit area SCA.

According to some embodiments, the shielding portion SHD may be integral with the second reset voltage line VRLv. The shielding portion SHD may extend from the second reset voltage line VRLv to overlap an area where a read-out line ROL to be described below and the horizontal connection line DBLh intersect with each other.

According to some embodiments, the shielding portion SHD may extend in the second direction (y direction) to overlap the fifth semiconductor pattern 1530. The shielding portion SHD may function as an upper protection metal protecting an active region of the second detection transistor S-T2.

Referring to FIG. 13, a third electrode layer 1900 may be located on an insulating layer covering the second electrode layer 1800. The third electrode layer 1900 may include a low-resistance metal material. For example, the third electrode layer 1900 may include a conductive material including Mo, Al, Cu, Ti, or the like and may include a layer or layers including the aforementioned material.

The third electrode layer 1900 may include a sixteenth electrode pattern 1910, a seventeenth electrode pattern 1920, a data line DL, a vertical connection line DBLv, a vertical voltage line VLv, and a read-out line ROL.

The sixteenth electrode pattern 1910 may be arranged in the first pixel circuit area PCA1 and may have an isolated shape. The sixteenth electrode pattern 1910 may be connected to the twelfth electrode pattern 1820 of the second electrode layer 1800 through a contact hole. Through the second electrode pattern 1713, the twelfth electrode pattern 1820, and the sixteenth electrode pattern 1910, the second terminal of the sixth transistor T6 and the pixel electrode of the light-emitting diode ED (see FIG. 5) may be electrically connected to each other.

The seventeenth electrode pattern 1920 may be arranged in the sensor circuit area SCA and may have an isolated shape. The seventeenth electrode pattern 1920 may be connected to the sixteenth electrode pattern 1860 of the second electrode layer 1800 through a contact hole. The gate electrode of the first detection transistor S-T1 and the detection electrode of the photo diode PD (see FIG. 5) may be electrically connected to each other through the ninth electrode pattern 1727, the sixteenth electrode pattern 1860, and the seventeenth electrode pattern 1920.

The data line DL, the vertical connection line DBLv, and the vertical voltage line VLv may extend in the second direction (y direction) to cross the first pixel circuit area PCA1.

The data line DL may be connected to the thirteenth electrode pattern 1830 of the second electrode layer 1800 through a contact hole. The first terminal of the second transistor T2 and the data line DL may be electrically connected to each other through the seventh electrode pattern 1723 and the thirteenth electrode pattern 1830.

The vertical connection line DBLv may correspond to any one of the second connection lines described with reference to FIG. 2. The vertical connection line DBLv may be electrically connected to a corresponding horizontal connection line DBLh through a contact hole.

The vertical voltage line VLv may be electrically connected to the 2nd-1 initialization voltage line VAIL1 or the 2nd-2 initialization voltage line VAIL2 through the eleventh electrode pattern 1810 of the second electrode layer 1800. For example, the vertical voltage line VLv connected to the 2nd-1 initialization voltage line VAIL1 may receive the 2nd-1 initialization voltage, and the vertical voltage line VLv connected to the 2nd-2 initialization voltage line VAIL2 may receive the 2nd-2 initialization voltage.

The read-out line ROL (signal line) may extend in the second direction (y direction) to cross the sensor circuit area SCA. According to some embodiments, the read-out line ROL may extend along an imaginary straight line extending in the second direction (y direction) to cross the sensor circuit area SCA without a curved portion.

The read-out line ROL may be connected to the ninth electrode pattern 1727 of the first electrode layer 1700 through a contact hole. The second terminal of the third detection transistor S-T3 may be electrically connected to the read-out line ROL through the ninth electrode pattern 1727.

According to some embodiments, each of the insulating layers arranged between the first electrode layer 1700 and the second electrode layer 1800 and between the second electrode layer 1800 and the third electrode layer 1900 may include a layer or layers including an organic insulating material.

Referring to FIGS. 14 and 15, the first electrode layer 1700 including the horizontal connection line DBLh may be arranged between an interlayer insulating layer 205 and a first planarization layer 206.

The second electrode layer 1800 including a fourteenth electrode pattern 1840, a fifteenth electrode pattern 1850, and a second reset voltage line VRLv may be located on the first planarization layer 206 covering the first electrode layer 1700. The fourteenth electrode pattern 1840 and the fifteenth electrode pattern 1850 may be arranged in the first pixel circuit area PCA1. The second reset voltage line VRLv may be arranged in the sensor circuit area SCA.

The third electrode layer 1900 including a vertical connection line DBLv, a data line DL, and a read-out line ROL may be located on a second planarization layer 207 covering the second electrode layer 1800. A third planarization layer 208 may cover the third electrode layer 1900.

The vertical connection line DBLv and the data line DL may overlap the fourteenth electrode pattern 1840 and the fifteenth electrode pattern 1850, respectively, and may be arranged in the first pixel circuit area PCA1. The read-out line ROL may overlap the shielding portion SHD extending in the first direction (x direction) from the second reset voltage line VRLv and may be arranged in the sensor circuit area SCA.

In a plan view, the read-out line ROL extending in the second direction (y direction) may intersect, in the sensor circuit area SCA, with the horizontal connection line DBLh extending in the first direction (x direction). A distance in a thickness direction (z direction) between the read-out line ROL and the horizontal connection line DBLh at a point where the read-out line ROL and the horizontal connection line DBLh intersect with each other may be very short. Therefore, parasitic capacitance may occur between the read-out line ROL and the horizontal connection line DBLh, and a read-out signal and a data signal may interfere with each other, resulting in a deterioration in the signal-to-noise ratio of the light detector LS.

The display apparatus 10 according to embodiments may include a shielding portion SHD protruding from the second reset voltage line VRLv, and the shielding portion SHD may be placed between a read-out line ROL and a horizontal connection line DBLh.

The shielding portion SHD may cover a portion of the horizontal connection line DBLh intersecting the read-out line ROL. The shielding portion SHD may prevent or reduce parasitic capacitance between the read-out line ROL and the horizontal connection line DBLh. Accordingly, the display apparatus 10, which not only acquires image information sensitively with an improved signal-to-noise ratio but also displays high-quality images, may be provided.

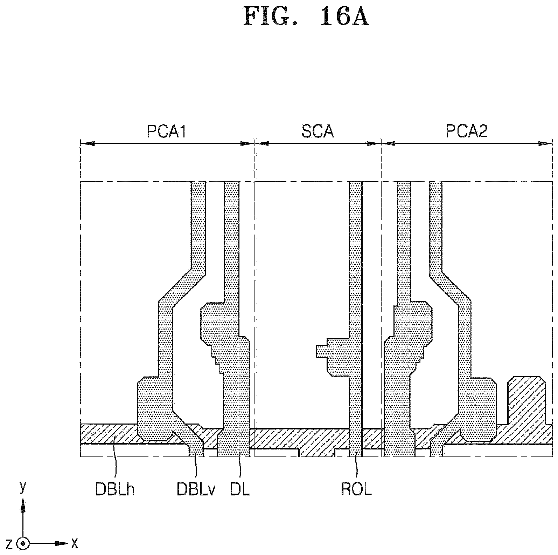

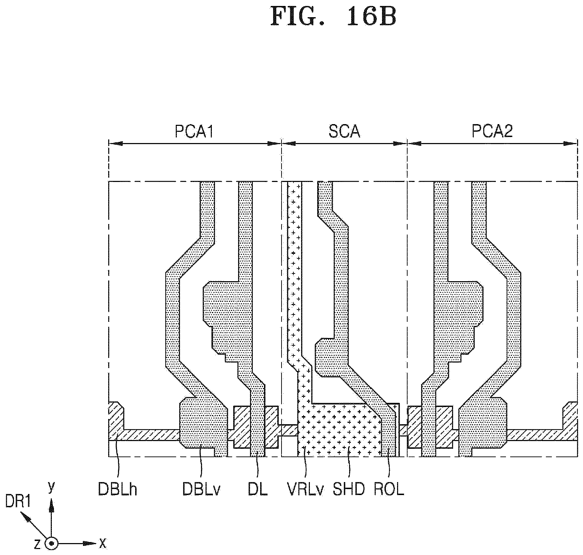

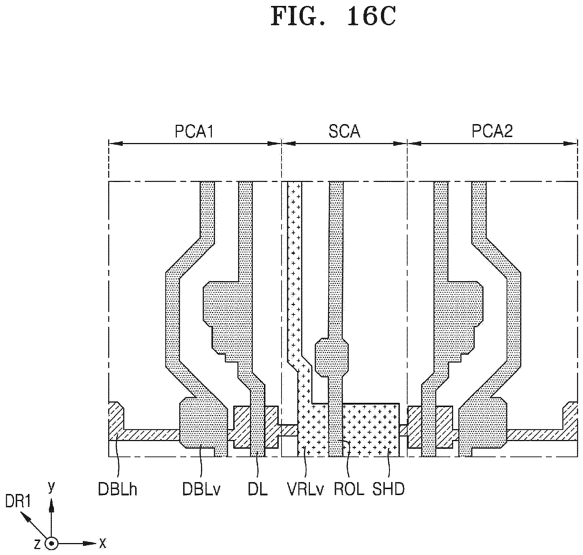

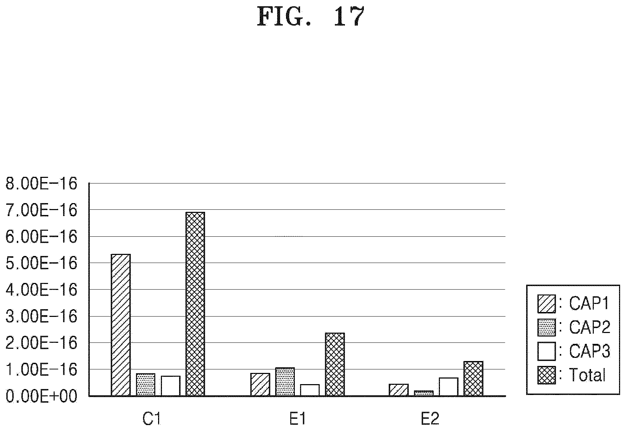

FIG. 16A is a plan view of a display apparatus according to a comparative example, FIGS. 16B and 16C are plan views of a display apparatus according to embodiments, and FIG. 17 is a graph showing parasitic capacitance between lines of the display apparatuses shown in FIGS. 16A, 16B, and 16C.

FIG. 16A shows a display apparatus according to a comparative example (C1), FIG. 16B shows a display apparatus according to a first embodiment (E1), and FIG. 16C shows a display apparatus according to a second embodiment (E2).

Referring to FIGS. 16A to 16C, a data line DL and a vertical connection line DBLv, which extend in the second direction (y direction), may be arranged in each of the first pixel circuit area PCA1 and the second pixel circuit area PCA2 of each display apparatus, and a read-out line ROL extending in the second direction (y direction) may be arranged in the sensor circuit area SCA.

A horizontal connection line DBLh may extend in the first direction (x direction) to cross the first pixel circuit area PCA1, the sensor circuit area SCA, and the second pixel circuit area PCA2.

A first parasitic capacitance CAP1 may occur between the read-out line ROL and the horizontal connection line DBLh, and a second parasitic capacitance CAP2 may occur between the read-out line ROL and the data line DL of the second pixel circuit area PCA2. In addition, a third parasitic capacitance CAP3 may occur between the read-out line ROL and the data line DL of the first pixel circuit area PCA1.

In the comparative example (C1), the first parasitic capacitance CAP1 may be 5.33×10⁻¹⁶ F, the second parasitic capacitance CAP2 may be 8.47×10⁻¹⁷ F, the third parasitic capacitance CAP3 may be 7.73×10⁻¹⁷ F, and the total capacitance Total, which is the sum of the first parasitic capacitance CAP1, the second parasitic capacitance CAP2, and the third parasitic capacitance CAP3, may be 6.95×10⁻¹⁶ F.

In the first embodiment (E1), the first parasitic capacitance CAP1 may be 8.85×10⁻¹⁷ F, the second parasitic capacitance CAP2 may be 1.06×10⁻¹⁶ F, the third parasitic capacitance CAP3 may be 4.52×10⁻¹⁷ F, and the total capacitance Total may be 2.39×10⁻¹⁶ F.

In the second embodiment (E2), the first parasitic capacitance CAP1 may be 4.37×10⁻¹⁷ F, the second parasitic capacitance CAP2 may be 2.02×10⁻¹⁷ F, the third parasitic capacitance CAP3 may be 6.75×10⁻¹⁷ F, and the total capacitance Total may be 1.31×10⁻¹⁶ F.

In the display apparatus according to the comparative example (C1) shown in FIG. 16A, a shielding portion is not arranged between the read-out line ROL and the horizontal connection line DBLh. On the other hand, the display apparatuses according to the embodiments (E1 and E2) shown in FIGS. 16B and 16C may include the second reset voltage line VRLv having a shielding portion SHD that extends in the second direction (y direction) in the sensor circuit area SCA and protrudes in the first direction (x direction) to overlap the horizontal connection line DBLh in a plan view. In this way, when the shielding portion SHD is placed between the read-out line ROL and the horizontal connection line DBLh, the first parasitic capacitance CAP1 between the read-out line ROL and the horizontal connection line DBLh may significantly decrease. As described above, in the comparative example (C1), the first parasitic capacitance CAP1 is 5.33×10⁻¹⁶ F, whereas in the first embodiment (E1), the first parasitic capacitance CAP1 may be greatly reduced to 8.85×10⁻¹⁷ F, and in the second embodiment (E2), the first parasitic capacitance CAP1 may be greatly reduced to 4.37×10⁻¹⁷ F.

In the first embodiment E1, a portion of the read-out line ROL may extend in an oblique direction DR1 crossing the first direction (x direction) and the second direction (y direction). In the second embodiment E2, the read-out line ROL may extend along an imaginary straight line extending in the second direction (y direction) to cross the sensor circuit area SCA without a curved portion. Therefore, compared to the first embodiment E1, in the second embodiment E2, a horizontal direction (x direction and/or y direction) component of the first parasitic capacitance CAP1 between the read-out line ROL and the horizontal connection line DBLh may be additionally reduced.

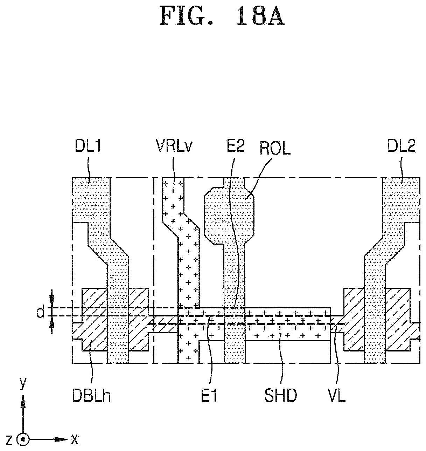

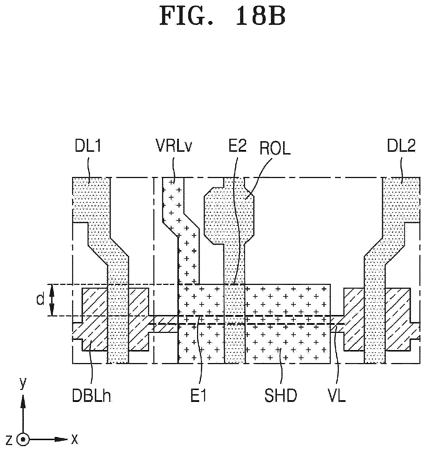

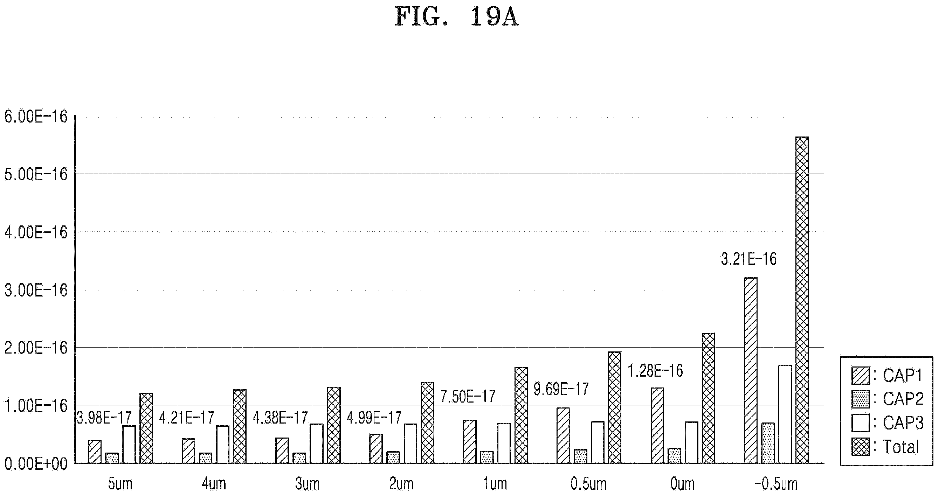

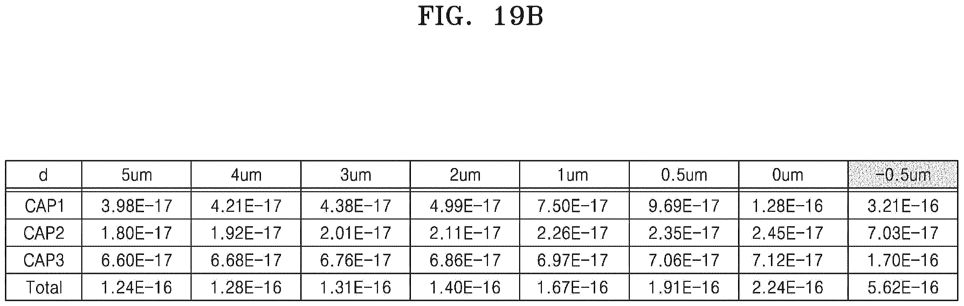

FIGS. 18A and 18B are plan views of a display apparatus according to embodiments, FIG. 19A is a graph showing parasitic capacitance according to a distance between a boundary of a data line and a boundary of a shielding portion, and FIG. 19B is a table showing parasitic capacitance according to a distance between a boundary of a data line and a boundary of a shielding portion.

Referring to FIGS. 18A and 18B, the horizontal connection line DBLh may extend in the first direction (x direction) and intersect a second reset voltage line VRLv, a read-out line ROL, a first data line DL1, and a second data line DL2, which extend in the second direction (y direction).

The second reset voltage line VRLv may have a shielding portion SHD protruding in the first direction (x direction) to overlap the horizontal connection line DBLh in a plan view. The width of the horizontal connection line DBLh in the second direction (y direction) may be less than the width of the shielding portion SHD in the second direction (y direction). In other words, a portion of the horizontal connection line DBLh adjacent to the read-out line ROL in a plan view may be covered by the shielding portion SHD.

An upper side (+y direction) boundary E1 of the horizontal connection line DBLh extending in the first direction (x direction) may be located closer to the imaginary line VL passing through the center of the horizontal connection line DBLh than an upper side (+y direction) boundary E2 of the shielding portion SHD extending in the first direction (x direction). The upper side (+y direction) boundary E2 of the shielding portion SHD may be spaced apart from the upper side (+y direction) boundary E1 of the horizontal connection line DBLh to the outside of the horizontal connection line DBLh by a first distance d. In this case, the outside of the horizontal connection line DBLh may mean a far side based on the imaginary line VL passing through the center of the horizontal connection line DBLh.

As shown in FIGS. 18A and 18B, the first distance d between the upper side (+y direction) boundary E2 of the shielding portion SHD and the upper side (+y direction) boundary E1 of the horizontal connection line DBLh may be changed. According to some embodiments, the first distance d may be about 2 µm to about 5 µm.

A first parasitic capacitance CAP1 may occur between the read-out line ROL and the horizontal connection line DBLh, a second parasitic capacitance CAP2 may occur between the read-out line ROL and the second data line DL2, and a third parasitic capacitance CAP3 may occur between the read-out line ROL and the first data line DL1.

FIGS. 19A and 19B are a graph and a table, respectively, which show values obtained by measuring the first parasitic capacitance CAP1, the second parasitic capacitance CAP2, and the third parasitic capacitance CAP3 while changing the first distance d from about -0.5 µm to about 5 µm, and the value of the total capacitance Total, which is the sum of the first parasitic capacitance CAP1, the second parasitic capacitance CAP2, and the third parasitic capacitance CAP3.

In this case, the fact that the first distance d has a negative value means that the upper side (+y direction) boundary E2 of the shielding portion SHD is located inside the horizontal connection line DBLh from the upper side (+y direction) boundary E1 of the horizontal connection line DBLh. The inside of the horizontal connection line DBLh may mean a side close to the imaginary line VL passing through the center of the horizontal connection line DBLh.

Referring to FIGS. 19A and 19B, it may be seen that the first parasitic capacitance CAP1, the second parasitic capacitance CAP2, and the third parasitic capacitance CAP3 decrease as the first distance d increases.

When the first distance d is greater than or equal to about 2 µm, the first parasitic capacitance CAP1 may be reduced to 4.99×10⁻¹⁷ F or less, and thus, the signal-to-noise ratio of the light detector LS may be significantly reduced. As the first distance d increases, the first parasitic capacitance CAP1, the second parasitic capacitance CAP2, and the third parasitic capacitance CAP3 decrease, but the first distance d may be about 5 µm or less due to peripheral components, such as a contact hole for connecting the read-out line ROL to the ninth electrode pattern 1727 (see FIG. 11). According to some embodiments, according to the first distance d, the shielding portion SHD may be provided integrally with an upper protection metal overlapping the fifth semiconductor pattern 1530 (see FIG. 10). In other words, the shielding portion SHD may overlap the fifth semiconductor pattern 1530 (see FIG. 10).

As discussed, embodiments provide a display apparatus including a plurality of pixels and a plurality of light detectors, the display apparatus comprising: a first electrode layer on a substrate and including a first connection line extending in a first direction; a second electrode layer on the first electrode layer, the second electrode layer including a first voltage line extending in a second direction crossing the first direction and a shielding portion protruding from the first voltage line in the first direction to overlap the first connection line; and a third electrode layer on the second electrode layer and including a second connection line and a signal line extending in the second direction.

The first and second connection lines may connect a data line in a display area to an input line in a peripheral area. For example, the data line and input line may extend in the second direction, but may be offset from each other in the first direction. The input line may be connected to a second connection line, which is connected to a first connection line, which is connected to the data line.

The first voltage line may be a reset voltage line.

The signal line may be a read-out line.

The shielding portion may cover a portion of the first connection line passing through a sensor circuit area.

According to some embodiments of the disclosure as described above, a display apparatus that displays relatively high-quality images may be implemented. However, the scope of embodiments according to the present disclosure is not limited by these effects.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims, and their equivalents.

## Claims

1. A display apparatus including a plurality of pixels and a plurality of light detectors, the display apparatus comprising:
a first electrode layer on a substrate and including a first connection line extending in a first direction;
a second electrode layer on the first electrode layer, the second electrode layer including a first voltage line extending in a second direction crossing the first direction and a shielding portion protruding from the first voltage line in the first direction to overlap the first connection line; and
a third electrode layer on the second electrode layer and including a second connection line and a signal line extending in the second direction.

2. The display apparatus of claim 1, wherein each of the plurality of light detectors includes a photo diode and a sensor circuit electrically connected to the photo diode.

3. The display apparatus of claim 2, wherein the sensor circuit includes:
a first detection transistor including a gate electrode electrically connected to the photo diode, a first terminal, and a second terminal;
a second detection transistor electrically connected between the gate electrode of the first detection transistor and the first voltage line; and
a third detection transistor electrically connected between the second terminal of the first detection transistor and the signal line.

4. The display apparatus of claim 2 or 3, wherein the shielding portion overlaps the second detection transistor.

5. The display apparatus of any one of claims 2 to 4, wherein the signal line crosses a sensor circuit area where the sensor circuit is arranged.

6. The display apparatus of any one of claims 1 to 5, wherein the signal line extends along a straight line extending in the second direction.

7. The display apparatus of any one of claims 1 to 6, wherein the signal line overlaps the shielding portion.

8. The display apparatus of any one of claims 1 to 7, wherein the shielding portion is integral with the first voltage line as a single body;
optionally wherein the shielding portion extends from the first voltage line to overlap a region where the signal line and the first connection line cross each other.

9. The display apparatus of any one of claims 1 to 8, wherein the first connection line has a first width in the second direction, and the shielding portion has a second width in the second direction,
wherein the first width is less than the second width.

10. The display apparatus of any one of claims 1 to 9, wherein one boundary of the shielding portion extending in the first direction is spaced apart from one boundary of the first connection line extending in the first direction by a first distance,
wherein the first distance is in a range of 2 µm to 5 µm.

11. The display apparatus of any one of claims 1 to 10, wherein the third electrode layer further includes a data line extending in the second direction,
wherein the second connection line is electrically connected to the data line and the first connection line;
optionally wherein the second connection line and the data line are integral with each other as a single body.

12. The display apparatus of any one of claims 1 to 11, wherein the first connection line is electrically connected to the second connection line within a display area.

13. The display apparatus of any one of claims 1 to 12, wherein each of the plurality of pixels includes a light-emitting diode and a pixel circuit electrically connected to the light-emitting diode,
wherein the pixel circuit includes:
a driving transistor including a gate electrode electrically connected to a first node, a first terminal electrically connected to a second node, and a second terminal electrically connected to a third node;
a data write transistor electrically connected between a data line and the first node;
a compensation transistor electrically connected between the first node and the third node;
a first initialization transistor electrically connected between the first node and a first initialization voltage line;
a second initialization transistor electrically connected between the third node and a second initialization voltage line; and
a storage capacitor electrically connected between a second voltage line and the first node;
optionally wherein the second voltage line overlaps the compensation transistor and the first initialization transistor;
optionally wherein the third electrode layer further includes the data line, and the second connection line and the data line cross a pixel circuit area where the pixel circuit is arranged.

14. The display apparatus of claim 13 when dependent on claim 2,
the light-emitting diode includes a pixel electrode, an opposite electrode, and a first intermediate layer between the pixel electrode and the opposite electrode, and
the photo diode includes a sensor electrode, an opposite electrode, and a second intermediate layer between the sensor electrode and the opposite electrode of the photo diode,
wherein the opposite electrode of the light-emitting diode and the opposite electrode of the photo diode are integrally provided as a single body.

15. The display apparatus of claim 14, wherein the sensor circuit is between a first pixel circuit and a second pixel circuit adjacent to each other;
optionally wherein the first pixel circuit and the second pixel circuit have a symmetrical shape with the sensor circuit therebetween;
optionally wherein the signal line is between a data line electrically connected to the first pixel circuit and a data line electrically connected to the second pixel circuit.
